# EUROPEAN PATENT SPECIFICATION

(11) **EP 2 657 974 B1**
(45) Date of publication and mention of the grant of the patent: **08.02.2017**
(21) Application number: 11851182.3
(22) Date of filing: 15.12.2011
(51) Int. Cl.: H01L 29/786, G02F 1/1368, G09F 9/30, H01L 21/336, H01L 51/50, H01L 29/66, H01L 27/12

(54) **SEMICONDUCTOR DEVICE AND DISPLAY DEVICE**
HALBLEITERVORRICHTUNG UND ANZEIGEVORRICHTUNG
DISPOSITIF SEMICONDUCTEUR ET DISPOSITIF D'AFFICHAGE

(30) Priority: 20.12.2010 JP 2010282919
(43) Date of publication of application: 30.10.2013
(73) Proprietor: Sharp Kabushiki Kaisha, Osaka-shi, Osaka 545-8522 (JP)
(72) Inventor: MORIGUCHI Masao, Osaka-shi, Osaka 545-8522 (JP); KANZAKI Yohsuke, Osaka-shi, Osaka 545-8522 (JP); TAKANISHI Yudai, Osaka-shi, Osaka 545-8522 (JP); KUSUMI Takatsugu, Osaka-shi, Osaka 545-8522 (JP); MATSUKIZONO Hiroshi, Osaka-shi, Osaka 545-8522 (JP)
(74) Representative: Müller Hoffmann & Partner
(86) International application number: PCT/JP2011/079036
(87) International publication number: WO 2012/086513

(56) References cited:
- WO-A2-2010/002807
- JP-A- 2010 135 762
- JP-A- 2010 251 735
- JP-A- 2012 009 843
- US-A1- 2010 065 844
- US-A1- 2010 110 623
- US-A1- 2010 213 459

## Description

### TECHNICAL FIELD

The present invention relates to a semiconductor device and display device, each including a thin-film transistor.

### BACKGROUND ART

An active-matrix-addressed liquid crystal display device or an organic EL (electroluminescence) display device generally includes a substrate on which thin-film transistors (which will also be referred to herein as "TFTs") are provided as switching elements for respective pixels (such a substrate will be referred to herein as a "TFT substrate"), a counter substrate on which a counter electrode, color filters and other members are arranged, and a light modulating layer such as a liquid crystal layer which is interposed between the TFT substrate and the counter substrate.

On the TFT substrate, arranged are a plurality of source lines, a plurality of gate lines, a plurality of TFTs which are located at their intersections, pixel electrodes to apply a voltage to the light modulating layer such as a liquid crystal layer, storage capacitor lines, storage capacitor electrodes, and so on.

A configuration for a TFT substrate is disclosed in Patent Document No. 1, for example. Hereinafter, the configuration of the TFT substrate disclosed in Patent Document No. 1 will be described with reference to the accompanying drawings.

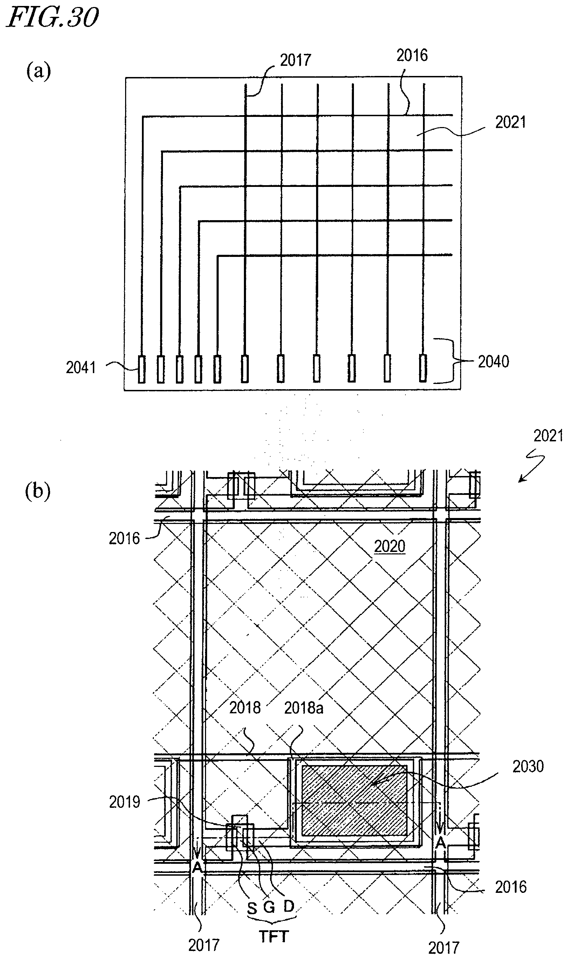

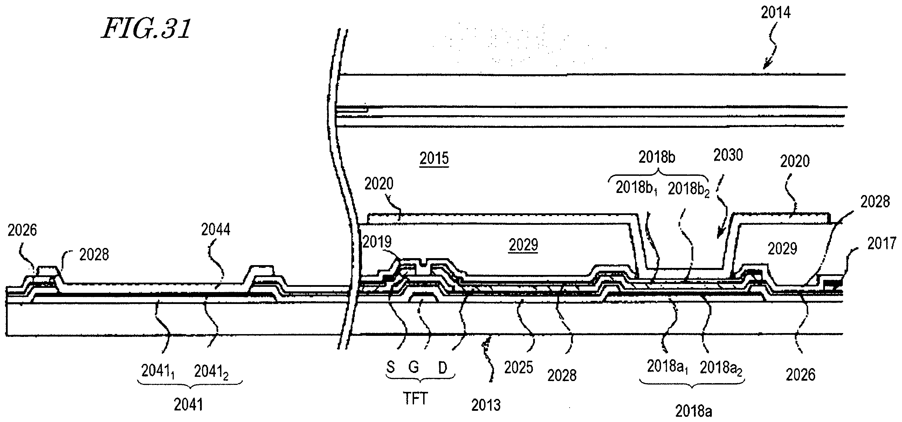

FIG. **30(a)** is a schematic plan view generally illustrating what the TFT substrate is like. FIG. **30(b)** is an enlarged plan view illustrating a single pixel of the TFT substrate. And FIG. 31 is a cross-sectional view illustrating the TFT and terminal portion of the semiconductor device shown in FIG. **30****.**

As shown in FIG. **30(a)****,** the TFT substrate includes a plurality of gate lines **2016** and a plurality of source lines **2017.** Each of multiple regions **2021** surrounded with these lines **2016** and **2017** defines a "pixel". On the area **2040** of the TFT substrate other than its area where pixels are arranged (i.e., its display area), arranged are a plurality of connecting portions **2041** which connect those gate lines **2016** and source lines **2017** to their drivers. These terminal portions **2041** together form a terminal section to be connected to an external line.

As shown in FIGS. **30 (b)** and **31,** a pixel electrode **2020** is arranged so as to cover each region **2021** to define a pixel. Also, a TFT has been formed in each region **2021.** The TFT includes a gate electrode **G,** a gate insulating film **2025, 2026** which covers the gate electrode **G,** a semiconductor layer **2019** stacked on the gate insulating film **2026,** and source and drain electrodes **S** and **D** which are connected to both ends of the semiconductor layer **2019.** The TFT is covered with a protective film **2028.** The gap between the protective film **2028** and the pixel electrode **2020** is filled with an interlevel dielectric film **2029.** The source electrode **S** of the TFT is connected to one of the source lines **2017** and its gate electrode **G** is connected to one of the gate lines **2016.** And its drain electrode **D** is connected to the pixel electrode **2020** in a contact hole **2030.**

Also, a storage capacitor line **2018** is arranged parallel to each gate line **2016,** and is connected to a storage capacitor. In this case, the storage capacitor is comprised of a storage capacitor electrode **2018b** which is made of the same conductive film as the drain electrode **D,** another storage capacitor electrode **2018a** which is made of the same conductive film as the gate line **2016,** and a gate insulating film **2026** interposed between them.

Each connecting section **2041** extended from each gate line **2016** or source line **2017** is not covered with the gate insulating film **2025, 2026** or the protective film **2028.** Instead, a connector line **2044** is arranged in contact with the upper surface of the connecting section **2041.** In this manner, electrical connection is established between the connecting section **2041** and the connector line **2044.**

Also, as shown in FIG. **31****,** in the liquid crystal display device, the TFT substrate is arranged to face the substrate **2014** on which the counter electrode and color filters have been formed with a liquid crystal layer **2015** interposed between them.

In fabricating such a TFT substrate, the region **2021** to define a pixel (which will be sometimes referred to herein as a "pixel section") and a terminal section are suitably formed by the same process in order to minimize an increase in the number of masks to use or the number of processing steps to perform.

To fabricate such a TFT substrate, portions of the gate insulating film **2025, 2026** and protective film **2028** need to be etched away from a terminal arrangement region **2040** and portions of the gate insulating film **2025** and the protective film **2028** need to be etched away from a region where a storage capacitor is going to be formed. Patent Document No. 1 discloses making an interlevel dielectric film **2029** of an organic insulating film and etching the insulating film **2025, 2026** and the protective film **2028** using that interlevel dielectric film **2029** as a mask.

Recently, people have proposed that a channel layer be formed for a TFT using an oxide semiconductor film of IGZO (InGaZnOₓ), for example, instead of a silicon semiconductor film. Such a TFT will be referred to herein as an "oxide semiconductor TFT". Since an oxide semiconductor has higher mobility than amorphous silicon, the oxide semiconductor TFT can operate at higher speeds than an amorphous silicon TFT. Also, such an oxide semiconductor film can be formed by a simpler process than a polysilicon film, and therefore, is applicable to even a device that needs to cover a large area.

Patent Document No. 2 discloses an example of such an oxide semiconductor TFT. Meanwhile, Patent Document No. 3 discloses an example of a field effect transistor including an active layer made of an amorphous oxide semiconductor.

According to Patent Document No. 3, before an amorphous oxide semiconductor layer is formed on a substrate, the surface of the substrate is either irradiated with an ultraviolet ray in an ozone ambient or plasma or cleaned with hydrogen peroxide to form the amorphous oxide semiconductor layer as intended. Patent Document No. 3 also says that the process step of forming an active layer including an amorphous oxide is performed within an ambient such as an ozone gas or a nitrogen oxide gas and that after an amorphous oxide has been deposited on the substrate, a heat treatment is carried out at a higher temperature than the deposition temperature of the amorphous oxide.

### CITATION LIST

### PATENT LITERATURE

Patent Document No. 1: Japanese Laid-Open Patent Publication No. 2008-170664
Patent Document No. 2: Japanese Laid-Open Patent Publication No. 2003-298062
Patent Document No. 3: Japanese Laid-Open Patent Publication No. 2006-165531

US 2010/0065844 A1 discloses a thin film transistor including, on top of a gate electrode, a gate insulating film and a channel layer, an oxygen transmission film of SiO, and on top of the oxygen transmission film, an oxygen disturbance film of SiN. Specifically during manufacture of the thin film transistor, due to the oxygen transmission film, and when providing an oxygen atmosphere, one may provide for oxygen to reach the channel layer through the oxygen transmission film.

US 2010/0110623 A1 discloses a driver circuit including a thin film transistor formed as a layered structure, wherein on an oxide semiconductor film, a silicon oxide film is provided including an OH group, with a silicon nitride film still further on top.

### SUMMARY OF INVENTION

### TECHNICAL PROBLEM

In an oxide semiconductor TFT, however, during the manufacturing process of the TFT (e.g., during a heat treatment process step), oxygen deficiencies could be produced to produce carrier electrons and eventually generate unnecessary OFF-state current, which is a problem. In addition, in the process step of etching the source and drain electrodes and in the process step of depositing an insulating layer on the source and drain electrodes, the underlying oxide semiconductor layer could be subject to a reduction reaction and other kinds of damage, which is also a problem.

The present inventors discovered via experiments that in an oxide semiconductor TFT in which an oxide semiconductor layer contacted with the underlying gate insulating layer or the overlying protective layer, defect levels due to the presence of oxygen deficiencies would be produced easily inside the oxide semiconductor layer or in the vicinity of the interface between the oxide semiconductor layer and the insulating layer or the protective layer, thus causing a decline in the performance or reliability of the TFT and varying their quality significantly from one product to another.

Patent Document No. 3 proposes that after an amorphous oxide has been deposited, a heat treatment be carried out at a higher temperature than the deposition temperature of the amorphous oxide in order to obtain a transistor with good performance. Even when such a method is adopted, however, those defect levels to be caused due to the presence of oxygen deficiencies cannot be reduced and it is difficult to realize good TFT performance.

The present inventors perfected our invention in order to overcome the problems described above by providing a semiconductor device with excellent TFT performance with such defects which have been caused in the oxide semiconductor layer of the oxide semiconductor TFT reduced. Another object of the present invention is to provide a high-performance display device including such a semiconductor device as its TFT substrate.

### SOLUTION TO PROBLEM

A semiconductor device according to the present invention is a semiconductor device with a thin-film transistor as defined in independent claim 1

In one embodiment, the oxygen supplying layer has a thickness of 500 nm to 3500 nm.

In one embodiment, the third layer has a thickness of 50 nm to 500 nm.

In one embodiment, the semiconductor device includes:
a lower wiring which is made of the same material as the gate electrode; an upper wiring which is made of the same material as the source and drain electrodes; and a connecting portion which connects the upper and lower wirings together. In the connecting portion, the upper and lower wirings are connected together through a contact hole which runs through the gate insulating layer.

In one embodiment, in the connecting portion, the contact hole has been cut to run through the oxide semiconductor layer and the gate insulating layer, and the upper and lower wirings are connected together through the contact hole.

In one embodiment, the connecting portion includes: an insulating layer which has been formed on the lower wiring; the upper wiring which has been formed on the insulating layer; the first layer which has been formed on the upper wiring; the second layer which has been formed on the first layer; the third layer which has been formed on the second layer; and a conductive layer which has been formed on the third layer. A contact hole has been cut to run through the insulating layer, upper wiring, first layer, second layer and third layer of the connecting portion. And the lower and upper wirings are electrically connected together through the conductive layer that has been deposited in the contact hole.

In one embodiment, the connecting portion includes: an insulating layer which has been formed on the lower wiring; the upper wiring which has been formed on the insulating layer; the first layer which has been formed on the upper wiring;
the second layer which has been formed on the first layer; the third layer which has been formed on the second layer; and a conductive layer which has been formed on the third layer. A first contact hole has been cut to run through the first layer, second layer and third layer of the connecting portion. A second contact hole has been cut to run through the insulating layer, first layer, second layer and third layer of the connecting portion. The upper wiring and the conductive layer are electrically connected together inside the first contact hole. And the lower wiring and the conductive layer are electrically connected together inside the second contact hole.

In one embodiment, the semiconductor device includes a storage capacitor which includes: a storage capacitor electrode which is made of the same material as the gate electrode; the third layer which has been formed on and in contact with the storage capacitor electrode; and a storage capacitor counter electrode which has been formed on the third layer.

In one embodiment, the semiconductor device includes a storage capacitor which includes: a storage capacitor electrode which is made of the same material as the gate electrode; a first conductive layer which has been formed on and in contact with the storage capacitor electrode; the third layer which has been formed on and in contact with the first conductive layer; and a storage capacitor counter electrode which has been formed on the third layer.

In one embodiment, the semiconductor device includes a storage capacitor which includes: a storage capacitor electrode which is made of the same material as the gate electrode; the oxide semiconductor layer which has been formed on and in contact with the storage capacitor electrode; the third layer which has been formed on and in contact with the oxide semiconductor layer on the storage capacitor electrode; and a storage capacitor counter electrode which has been formed on the third layer.

A display device according to the present invention includes a semiconductor device according to any of the embodiments described above, and includes a pixel electrode which has been formed on the anti-diffusion layer. The pixel electrode is connected to the drain electrode through a contact hole that runs through the first layer, the second layer, and the third layer.

Another display device according to the present invention is a fringe field type display device including a semiconductor device according to any of the embodiments described above. The display device includes: a lower electrode which is arranged between the second layer and the third layer; and an upper electrode which is arranged on the third layer and connected to the drain electrode of the thin-film transistor.

In one embodiment, that another display device includes a common line which is made of the same material as the gate electrode. The common line and the lower electrode are connected together through a contact hole that runs through the gate insulating layer, the first layer, and the second layer.

In one embodiment of a semiconductor device according to the present invention, the first layer has a density of 1.9 to 2.2 g/cm³.

In one embodiment of a semiconductor device according to the present invention, the first layer is comprised of a first portion first layer which has been formed on the oxide semiconductor layer and the source and drain electrodes, and a second portion first layer which has been formed on the first portion first layer and which has a lower density than the first portion first layer.

In one embodiment, the first portion first layer has a density of 2.1 to 2.4 g/cm³ and the second portion first layer has a density of 1.9 to 2.2 g/cm³.

In one embodiment, the semiconductor device of the present invention includes an etch stopper layer which has been formed between the oxide semiconductor layer and the source and drain electrodes.

Another display device according to the present invention includes a semiconductor device according to any of these embodiments.

Another semiconductor device according to an example is a semiconductor device with a thin-film transistor, and includes: a gate electrode which has been formed on a substrate as a part of the thin-film transistor; a gate insulating layer which has been formed on the gate electrode; an oxide semiconductor layer which has been formed on the gate insulating layer; a source electrode and a drain electrode which are arranged on the oxide semiconductor layer as parts of the thin-film transistor; and an oxygen supplying layer which has been formed on the oxide semiconductor layer and the source and drain electrodes to contact with the oxide semiconductor layer.

In one embodiment, the semiconductor device includes a protective layer which is arranged between the oxide semiconductor layer, the source and drain electrodes, and the oxygen supplying layer, and the oxygen supplying layer contacts with the oxide semiconductor layer through a contact hole which has been cut through the protective layer.

In one embodiment, the semiconductor device includes an anti-diffusion layer which has been formed on the oxygen supplying layer.

In one embodiment, the semiconductor device includes an etch stopper layer which has been formed between the oxide semiconductor layer and the source and drain electrodes.

Another semiconductor device according to an example is a semiconductor device with a thin-film transistor, and includes: a gate electrode which has been formed on a substrate as a part of the thin-film transistor; a gate insulating layer which has been formed on the gate electrode; a source electrode and a drain electrode which have been formed on the gate insulating layer as parts of the thin-film transistor; an oxide semiconductor layer which has been formed on the gate insulating layer and the source and drain electrodes; a protective layer which has been formed on the oxide semiconductor layer; and an oxygen supplying layer which has been formed on the protective layer.

Another semiconductor device according to an example is a top gate type semiconductor device with a thin-film transistor, and includes: a source electrode and a drain electrode which have been formed on a substrate as parts of the thin-film transistor; an oxide semiconductor layer which has been formed on the source and drain electrodes; an insulating layer which has been formed on the oxide semiconductor layer and the source and drain electrodes; a gate electrode which has been formed on the insulating layer as a part of the thin-film transistor; an oxygen supplying layer which has been formed on the insulating layer and the gate electrode; and an anti-diffusion layer which has been formed on the oxygen supplying layer.

Another display device according to the present invention includes a semiconductor device according to any of the embodiments described above.

### ADVANTAGEOUS EFFECTS OF INVENTION

According to the present invention, H₂O, an OR group, or an OH group is supplied from the second (oxygen supplying) layer to the oxide semiconductor layer, and therefore, a high-performance semiconductor device including an oxide semiconductor layer, of which the defects have been repaired more perfectly, can be obtained. In addition, according to the present invention, a high-reliability semiconductor device, of which the characteristic varies much less significantly from one TFT to another, can also be obtained. Furthermore, according to the present invention, a display device with an oxide semiconductor TFT having excellent characteristics realizes a higher display quality.

### BRIEF DESCRIPTION OF DRAWINGS

[FIG. **1**] A perspective view schematically illustrating a configuration for a liquid crystal display device **1000** as a first embodiment of the present invention.
[FIG. **2**] A plan view schematically illustrating a configuration for the TFT substrate (semiconductor device **100**) of the liquid crystal display device **1000.**
[FIG. **3**] A plan view schematically illustrating the configuration of the TFT substrate **100** in its display area **DA.**
[FIG. **4**] A cross-sectional view schematically illustrating the configuration of a TFT **10** according to the first embodiment.
[FIG. **5**] A cross-sectional view schematically illustrating the configuration of, and the effects achieved by, the TFT **10** of the first embodiment.
[FIG. **6**] **(a)** and **(b)** are graphs showing what effects are achieved by the TFT **10,** wherein **(a)** shows the voltage-current characteristics of TFTs with an oxygen supplying layer, while **(b)** shows the voltage-current characteristics of TFTs with no oxygen supplying layer.
[FIG. **7**] **(a)** through **(d)** are cross-sectional views schematically illustrating respective manufacturing process steps to fabricate the TFT substrate **100.**
[FIG. **8**] **(e)** through **(g)** are cross-sectional views schematically illustrating respective manufacturing process steps to fabricate the TFT substrate **100.**
[FIG. **9**] A cross-sectional view schematically illustrating a first exemplary configuration for a connecting portion in which upper and lower wirings are connected together on the TFT substrate **100.**
[FIG. **10**] A cross-sectional view schematically illustrating a second exemplary configuration for a connecting portion on the TFT substrate **100.**
[FIG. **11**] A cross-sectional view schematically illustrating a third exemplary configuration for a connecting portion on the TFT substrate **100.**
[FIG. **12**] A cross-sectional view schematically illustrating the configuration of a TFT substrate **100** as a second embodiment of the present invention.
[FIG. **13**] A cross-sectional view schematically illustrating the configuration of a TFT substrate **100** as a first modified example of the second embodiment.
[FIG. **14**] A cross-sectional view schematically illustrating the configuration of a TFT substrate **100** as a second modified example of the second embodiment.
[FIG. **15**] A plan view schematically illustrating a configuration for a pixel **50** of a TFT substrate **100** as a third embodiment of the present invention.
[FIG. **16**] A cross-sectional view schematically illustrating the configuration of a TFT substrate **100** according to the third embodiment.
[FIG. **17**] A plan view schematically illustrating a configuration for a pixel 50 as a modified example of the third embodiment.
[FIG. **18**] A cross-sectional view schematically illustrating the configuration of a TFT **10** as a fourth embodiment of the present invention.
[FIG. **19**] A cross-sectional view schematically illustrating the configuration of a TFT **10** as a fifth embodiment of the present invention.
[FIG. **20**] A cross-sectional view schematically illustrating the configuration of a TFT **10** as a sixth embodiment of the present invention.
[FIG. **21**] A cross-sectional view schematically illustrating the configuration of a TFT **10** as a seventh embodiment of the present invention.
[FIG. **22**] A graph showing the voltage-current characteristics of the TFT **10** of the seventh embodiment to indicate what effects are achieved by the TFT **10.**
[FIG. **23**] A cross-sectional view schematically illustrating the configuration of a TFT **10** as an eighth embodiment of the present invention.
[FIG. **24**] A cross-sectional view schematically illustrating the configuration of a TFT **10** as a ninth embodiment of the present invention.
[FIG. **25**] A cross-sectional view schematically illustrating the configuration of a TFT **10** as a tenth embodiment of the present invention.
[FIG. **26**] A cross-sectional view schematically illustrating the configuration of a TFT **10** as an eleventh embodiment of the present invention.
[FIG. **27**] A cross-sectional view schematically illustrating the configuration of a TFT **10** as a twelfth embodiment of the present invention.
[FIG. **28**] A cross-sectional view schematically illustrating the configuration of a TFT **10** as an example.
[FIG. **29**] A cross-sectional view schematically illustrating the configuration of an organic EL display device **1002** as a further embodiment of the present invention.
[FIG. **30**] **(a)** is a schematic plan view generally illustrating what a conventional TFT substrate is like. **(b)** is an enlarged plan view illustrating a single pixel of the TFT substrate shown in FIG. **30(a)****.**
[FIG. **31**] A cross-sectional view illustrating the TFT and terminal portion of the conventional TFT substrate shown in FIG. **30****.**

### DESCRIPTION OF EMBODIMENTS

Hereinafter, embodiments of a display device and semiconductor device according to the present invention will be described with reference to the accompanying drawings. However, the present invention is in no way limited to the specific embodiments to be described below. A semiconductor device according to the present invention is a TFT substrate with an oxide semiconductor TFT, which may be used in any of various kinds of display devices and electronic devices. In the following description of embodiments, the semiconductor device is supposed to be a TFT substrate for a display device which includes an oxide semiconductor TFT as its switching element.

### (EMBODIMENT 1)

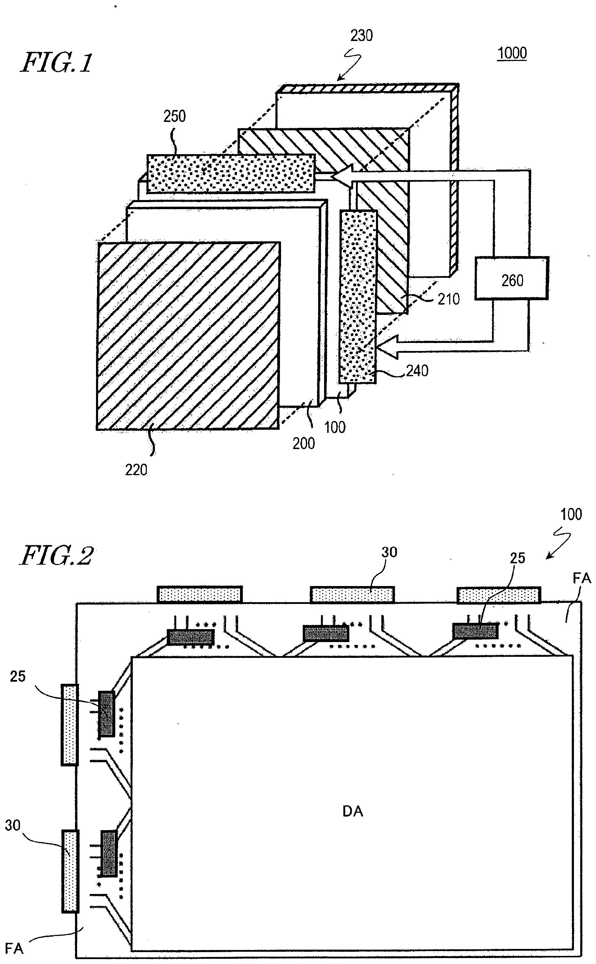

FIG. **1** is a perspective view schematically illustrating a configuration for a liquid crystal display device **1000** as an embodiment of the present invention.

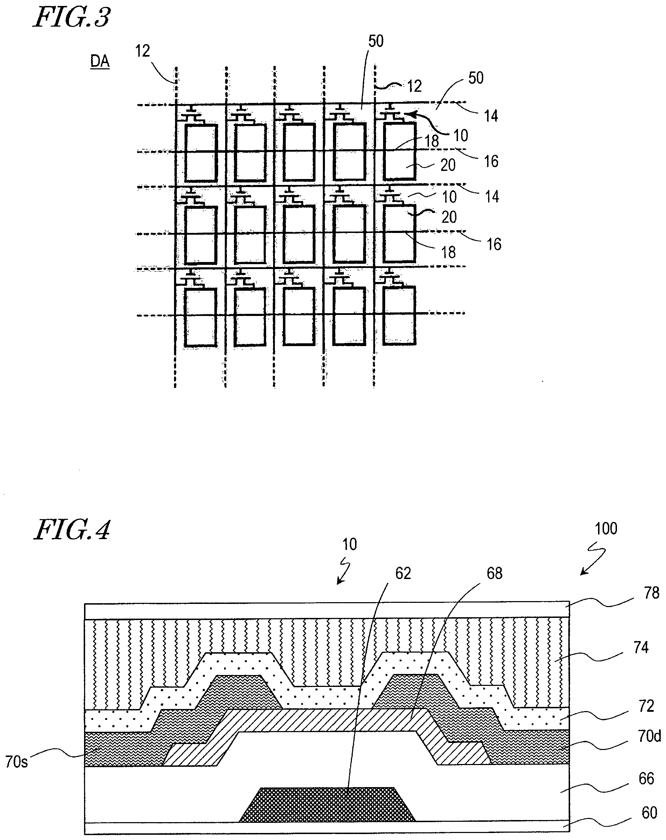

As shown in FIG. **1****,** this liquid crystal display device **1000** includes a TFT substrate (semiconductor device) **100** and a counter substrate **200** which face each other with a liquid crystal layer interposed between them, polarizers **210** and **220,** which are arranged outside of the TFT substrate **100** and the counter substrate **200,** respectively, and a backlight unit **230** which emits light for display toward the TFT substrate **100.** On the TFT substrate **100,** arranged are a scan line driver **240** which drives a plurality of scan lines (gate bus lines) and a signal line driver **250** which drives a plurality of signal lines (data bus lines). The scan line driver **240** and the signal line driver **250** are connected to a controller **260** which is arranged either inside or outside of the TFT substrate **100.** Under the control by the controller **260,** the scan line driver **240** supplies a scan signal to turn ON/OFF TFTs to those scan lines, and the signal line driver **250** supplies a display signal (which is a voltage to be applied to the pixel electrode **20** shown in FIG. **3**) to those signal lines.

The counter substrate **200** includes color filters and a common electrode. If a display operation is conducted in the three primary colors, the color filters include R (red), G (green) and B (blue) filters, each of which is arranged to face a pixel. Optionally, the counter substrate **200** may also be configured to carry out a display operation in four or more primary colors. The common electrode is arranged to cover a plurality of pixel electrodes **20** with the liquid crystal layer interposed between them. Liquid crystal molecules that are located between the common electrode and each pixel electrode **20** get aligned according to a potential difference created between those electrodes, thereby conducting a display operation.

FIG. **2** is a plan view schematically illustrating a configuration for the TFT substrate **100,** and FIG. **3** is a plan view schematically illustrating the configuration of the TFT substrate **100** in its display area **DA.**

As shown in FIG. **2****,** the TFT substrate **100** has the display area **DA** and a peripheral area (frame area) **FA** which surrounds the display area **DA.** In the peripheral area **FA,** the scan line driver **240** and signal line driver **250** shown in FIG. **1****,** electrical elements that form a voltage supply circuit and other components are arranged by the COG (chip on glass) method. The TFTs, diodes and other electrical elements in the peripheral area **FA** and the TFTs in the display area **DA** may be fabricated by performing the same series of manufacturing process steps. Furthermore, terminal portions **30,** to which an external element such as an FPC (flexible printed circuit) is attached, are arranged around the outer edge of the peripheral area **FA.** In addition, connecting portions **25** which electrically connect upper wirings such as the signal lines and lower wirings such as the scan lines are arranged in the peripheral area **FA.**

Although not shown, a plurality of connecting lines are arranged in the boundary between the display area **DA** and the peripheral area **FA.** Each signal line **12** is electrically connected to one of the connecting lines via its associated connecting portion. Through those connecting portions, the signal lines **12** as upper wirings are connected to the connecting lines as lower wirings.

As shown in FIG. **3****,** in the display area **DA,** a plurality of pixels **50** are arranged in matrix, and a plurality of scan lines **14** and a plurality of signal lines **12** run to cross each other at right angles. A portion of the scan line **14** functions as the gate electrode of the TFT **10.** A thin-film transistor (TFT) **10** as an active component is arranged for each pixel **50** in the vicinity of each of the intersections between the scan lines **14** and the signal lines **12.** In each of those pixels **50,** a pixel electrode **20** made of ITO (indium tin oxide) is arranged and electrically connected to the drain electrode of its associated TFT **10.** Also, a storage capacitor line (which will be sometimes referred to herein as a "Cs line") **16** runs parallel to, and between, two adjacent ones of the scan lines **14.**

In each pixel **10,** a storage capacitor (Cs) **18** has been formed, and a portion of the storage capacitor line **16** functions as the storage capacitor electrode (i.e., lower electrode) of the storage capacitor **18.** This storage capacitor electrode, a storage capacitor counter electrode (upper electrode) and a layer arranged between the two electrodes together form the storage capacitor **18.** The drain electrode of each TFT **10** is connected to the storage capacitor counter electrode of its associated storage capacitor. And the storage capacitor counter electrode is connected to its associated pixel electrode **20** through a contact hole which has been cut through an interlayer insulating layer. The gate electrodes of the respective TFTs **10,** the scan lines **14,** the storage capacitor lines **16** and the storage capacitor electrodes are basically formed of the same material in the same process step. Likewise, the source and drain electrodes of the TFTs **10,** the signal lines **12** and the storage capacitor counter electrodes are also basically formed of the same material in the same process step.

FIG. **4** is a cross-sectional view schematically illustrating the configuration of a TFT **10** on the TFT substrate **100** (which will also be referred to herein as the "semiconductor device 100") according to this first embodiment.

As shown in FIG. **4****,** the TFT **10** includes a gate electrode **62** which has been formed on a substrate **60** such as a glass substrate, a gate insulating layer **66** (which will be sometimes simply referred to herein as an "insulating layer" and) which has been formed on the substrate **60** to cover the gate electrode **62,** an oxide semiconductor layer **68** which has been stacked on the gate insulating layer **66,** a source electrode **70s** and a drain electrode **70d** which have been formed on the gate insulating layer **66** and the oxide semiconductor layer **68,** a protective layer **72** which has been formed on the source and drain electrodes **70s** and **70d,** an oxygen supplying layer **74** which has been stacked on the protective layer **72,** and an anti-diffusion layer **78** which has been stacked on the oxygen supplying layer **74.**

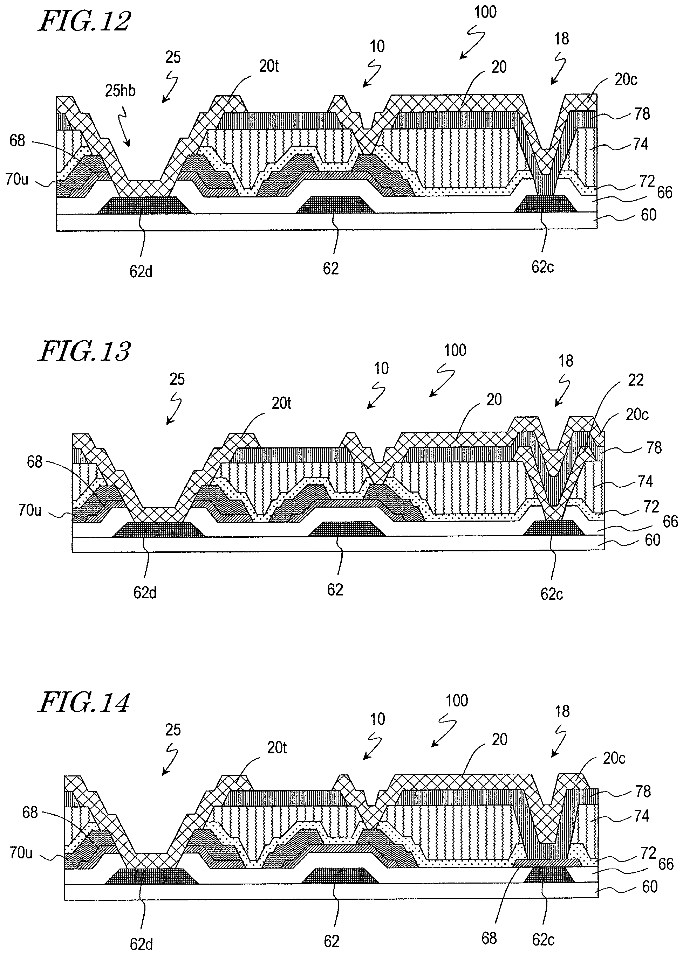

As will be described later with reference to FIGS. **12** through **14****,** a pixel electrode **20** of a transparent conductive material has been formed on the anti-diffusion layer **78.** A contact hole has been cut through the anti-diffusion layer **78,** the interlayer insulating layer **74** and the protective layer **72** under the pixel electrode **20,** and the pixel electrode **20** contacts with the drain electrode **70d** of the TFT **10** at the bottom of the contact hole.

The gate electrode **62** may have a double-layer structure in which an upper gate electrode of copper (Cu) has been stacked on a lower gate electrode of titanium (Ti), for example. Alternatively, the gate electrode may also have a triple-layer structure consisting of Ti, Al (aluminum) and Ti layers. The gate insulating layer **66** is made of silicon nitride, for example. Alternatively, the gate insulating layer **66** may be made of silicon dioxide. Or the gate insulating layer **66** may also have a double-layer structure consisting of a silicon nitride layer and a silicon dioxide layer.

The oxide semiconductor layer **68** is made of an In-Ga-Zn-O (IGZO) based semiconductor. The source electrode **70s** and the drain electrode **70d** which have been formed on the oxide semiconductor layer **68** are obtained by patterning a conductive layer with a triple-layer structure consisting of Ti, Al and Ti layers. Alternatively, the source electrode **70s** and the drain electrode **70d** may also have a double-layer structure consisting of Al and Ti layers, Cu and Ti layers or Cu and Mo (molybdenum) layers. The protective layer **72** is made of either silicon dioxide (SiO₂) or silicon nitride (SiNₓ). The anti-diffusion layer **78** is made of silicon dioxide (SiO₂), silicon nitride (SiNₓ) or silicon oxynitride (SiNO).

The oxygen supplying layer **74** is made of a material including water (H₂O), an OR group, or an OH group. In this embodiment, the oxygen supplying layer **74** has been formed by spin-coating the substrate with an acrylic resin, for example. The spin on glass (SOG) material may include a silicone resin, silanol (such as Si(OH)₄), alkoxy silane or siloxane resin, etc. Alternatively, the oxygen supplying layer **74** may also be made of any other resin material such as a silanol group or an Si-OH group. Still alternatively, the oxygen supplying layer **74** may also be made of a resin material such as an ester polymer resin or a CO-OR group.

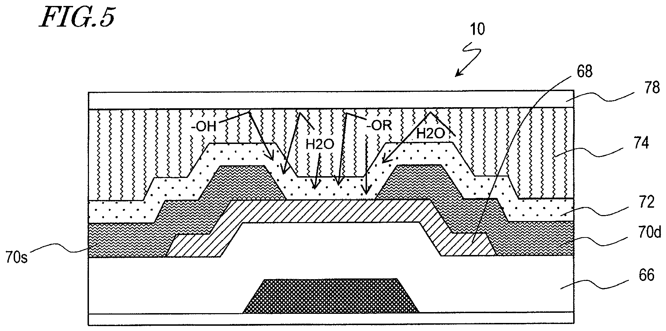

As shown in FIG. **5****,** since the oxygen supplying layer **74** includes H₂O, an OR group, or an OH group, that H₂O, an OR group, or an OH group diffuses from the oxygen supplying layer **74** toward the channel portion of the oxide semiconductor layer **68** through the protective layer **72** during a heat treatment process such as an annealing process, thus repairing defects that have been caused due to the presence of oxygen deficiencies in the oxide semiconductor layer **68.** As a result, a high-quality semiconductor device which has improved TFT performance and of which the characteristic varies much less significantly from one TFT to another can be provided. In addition, since the anti-diffusion layer **78** is arranged on the oxide semiconductor layer **74,** H₂O, OR groups, or OH groups which have moved upward from the oxygen supplying layer **74** are reflected from the bottom of the anti-diffusion layer **78** toward the oxide semiconductor layer **68.** That is why if the heat treatment process is carried out after the anti-diffusion layer **78** has been formed, more H₂O, OR groups, or OH groups are supplied onto the oxide semiconductor layer **68** and a lot more defects can be repaired.

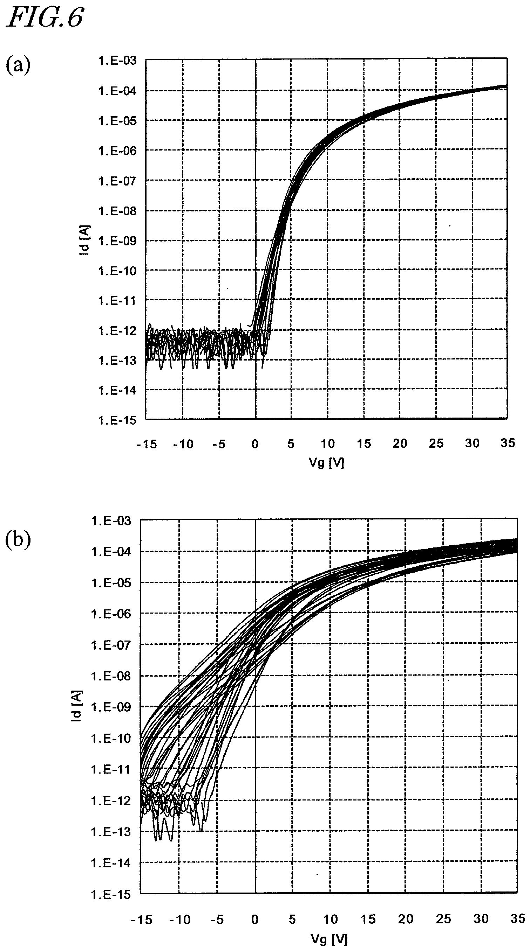

FIG. **6(a)** is a graph showing the voltage-current characteristics of multiple TFTs **10,** while FIG. **6(b)** is a graph showing the voltage-current characteristics of multiple TFTs with no oxygen supplying layer or anti-diffusion layer. In these graphs, the abscissa represents the gate voltage value and the ordinate represents the source-drain current value. As can be seen from FIG. **6(a)****,** in the TFTs **10** of the first embodiment, the amount of current flowing rises steeply at a gate voltage of around 0 V and there is less variation between the characteristics (i.e., S curves) of those TFTs **10.** These results reveal that in any of these TFTs **10,** an appropriate current value can be obtained according to the voltage applied, no sooner has the TFT **10** been turned ON. On the other hand, in the TFTs having no oxygen supplying layer or anti-diffusion layer, the amount of ON-state current flowing rises much less steeply, and there is a significant variation between their rising points as shown in FIG. **6(b)****.** In addition, there is a significant variation in OFF-state current value, too. Comparing these results, it can be seen that with the TFTs 10 of this first embodiment, a high-performance semiconductor device with further stabilized TFT characteristics can be obtained.

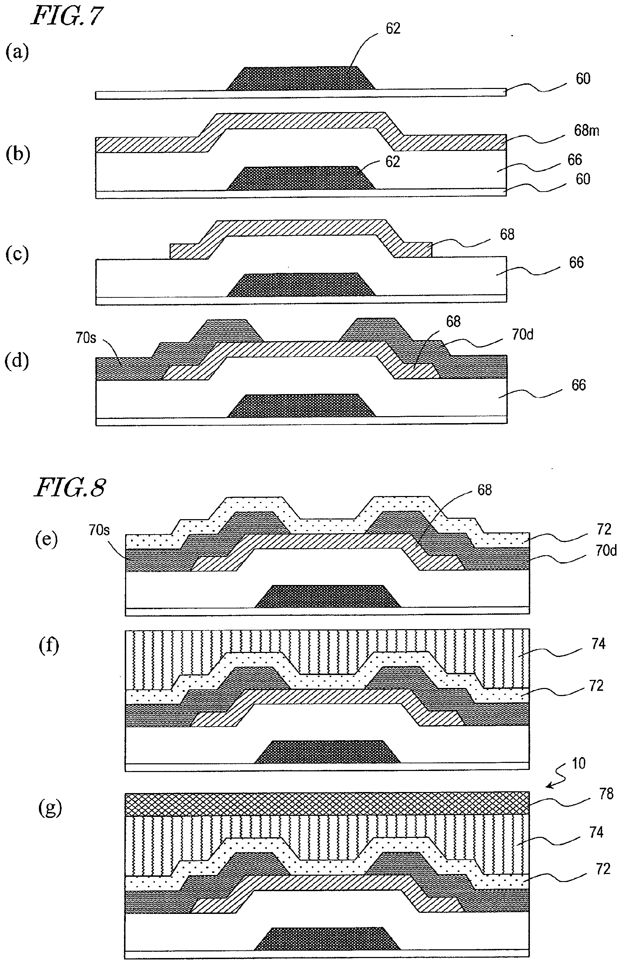

Hereinafter, it will be described with reference to FIGS. **7** and **8** how to fabricate the TFT substrate **100.**

FIGS. **7(a)** through **7(d)** and FIGS. **8(e)** through **8(g)** are schematic cross-sectional views illustrating the respective manufacturing process steps to fabricate the TFT substrate **100.**

### Step (A) :

First of all, Ti and Cu layers are stacked in this order on a substrate **60** by sputtering process, for example. In this case, the Ti layer may be deposited to a thickness of 30 to 150 nm, and the Cu layer may be deposited to a thickness of 200 to 500 nm. Next, these two layers stacked are patterned by known photolithography and wet etching techniques (which will be referred to herein as a "first masking process step"), thereby obtaining the gate electrode **62** shown in FIG. **7(a)****.** Although not shown in FIG. **7(a)****,** scan lines **14,** storage capacitor lines **16,** storage capacitor electrodes and lower wirings are also formed at the same time. After that, the remaining resist pattern is stripped and the substrate is cleaned.

### Step (B) :

Next, a gate insulating layer **66** is deposited over the substrate **60** so as to cover the gate electrode **62.** The gate insulating layer **66** may be a silicon nitride layer which has been deposited to a thickness of 100 to 700 nm by plasma CVD process. Alternatively, silicon dioxide (SiO₂) may be deposited instead of silicon nitride. Or silicon nitride and silicon dioxide may be both deposited.

Subsequently, as shown in FIG. **7(b)****,** an oxide semiconductor material **68m** is stacked on the gate insulating layer **66.** The oxide semiconductor material **68m** may be In-Ga-Zn-O (IGZO), for example, and may be deposited to a thickness of 10 to 100 nm by sputtering process. Alternatively, the oxide semiconductor material **68m** may be deposited by application or ink jet technique. The oxide semiconductor material does not have to be IGZO but may also be any other kind of oxide semiconductor material.

### Step (C) :

Thereafter, the oxide semiconductor material **68m** deposited is patterned by photolithographic process and wet etching process using oxalic acid, for example (which will be referred to herein as a "second masking process"), thereby obtaining an oxide semiconductor layer **68** including the channel layer of the TFT **10** as shown in FIG. **7(c)****.** After that, the remaining resist pattern is stripped and the substrate is cleaned.

### Step (D) :

Next, Ti, Al and Ti layers are deposited by sputtering process in this order over the gate insulating layer **66** to cover the oxide semiconductor layer **68.** Subsequently, these three layers are patterned by photolithographic and wet etching processes, thereby obtaining source and drain electrodes **70s** and **70d** as shown in FIG. **7(d)** (which will be referred to herein as a "third masking process"). After that, the remaining resist pattern is stripped and the substrate is cleaned. Optionally, the wet etching process may be replaced with a dry etching process. Also, instead of stacking Ti, Al and Ti layers, Al and Ti layers, Al and Mo layers, Cu and Ti layers, or Cu and Mo layers may be stacked. Still alternatively, any of these metals could be used as a single layer. In this process step, signal lines **12,** storage capacitor counter electrodes, upper wirings and other members (none of which are shown) are also formed at the same time.

### Step (E) :

Next, as shown in FIG. **8(e)****,** silicon dioxide is deposited by CVD process all over the substrate, thereby forming a protective layer **72.** Optionally, silicon nitride may be deposited instead of silicon dioxide, or silicon dioxide and silicon nitride may be stacked one upon the other. The protective layer **72** suitably has a thickness of 25 nm to 350 nm. The reason is as follows. Specifically, if the thickness of the protective layer **72** were less than 25 nm, the layer could not work fine as a protective layer and the reliability of the TFT would decrease. However, if the thickness of the protective layer **72** were greater than 350 nm, then there should be a concern about film peeling due to a film stress. Also, in that case, it would take a lot of time to deposit and etch the protective layer **72,** thus resulting in poor productivity.

### Step (F) :

Subsequently, as shown in FIG. **8(f)****,** the protective layer **72** is coated with an oxygen supplying material **74m** of an acrylic resin. Alternatively, the protective layer **72** may also be spin-coated with an SOG material such as a silicone resin. As the oxygen supplying material **74m,** a material including silanol (Si(OH)₄), alkoxy silane, or a siloxane resin may be used. Alternatively, the oxygen supplying layer **74** may also be made of any other resin material including a silanol group or an Si-OH group. Still alternatively, the oxygen supplying layer **74** may also be made of a resin material including an ester polymer resin or a CO-OR group. The oxygen supplying layer **74** suitably has a thickness of 500 nm to 3500 nm for the following reasons. Specifically, if the thickness of the oxygen supplying layer **74** were less than 500 nm, the effect of the present invention could not be achieved. However, if the thickness of the oxygen supplying layer **74** were greater than 3500 nm, then there should be a concern about film peeling or a decline in productivity.

### Step (G) :

Subsequently, silicon dioxide is deposited by CVD process over the entire surface of the substrate, as well as over the oxygen supplying layer **74,** thereby forming an anti-diffusion layer **78** as shown in FIG. **8(g)****.** Optionally, silicon nitride may be deposited instead of silicon dioxide, or silicon dioxide and silicon nitride may be stacked one upon the other.

The anti-diffusion layer **78** may have a thickness of 50 nm to 500 nm. Thereafter, an annealing process is carried out at a temperature of 200 to 400 °C in an air atmosphere, thereby completing the TFT **10.** If the anti-diffusion layer **78** is implemented as either a silicon nitride film or a stack of silicon dioxide and silicon nitride films and if the protective layer **72** is implemented as a silicon dioxide film, the good anti-diffusion effect and the protective film function can be achieved at the same time by the anti-diffusion layer **78** and the protective layer **72,** respectively. It should be noted that the protective layer **72** needs to have not only the function as a protective film but also the property to transmit H₂O, OR groups or OH groups appropriately. A silicon nitride film has the property of transmitting H₂O, OR groups or OH groups less easily than a silicon dioxide film.

During the annealing process, H₂O, OH groups or OR groups diffuse from the oxygen supplying layer **74** toward the channel portion of the oxide semiconductor layer **68** via the protective layer **72,** thereby repairing the defects that have been caused due to the presence of oxygen deficiencies in the oxide semiconductor layer **68.** Also, H₂O, OR groups, or OH groups which have moved upward from the oxygen supplying layer **74** are reflected from the bottom of the anti-diffusion layer **78** toward the oxide semiconductor layer **68.** That is why more H₂O, OR groups, or OH groups are supplied onto the oxide semiconductor layer **68** and a lot more defects can be repaired.

Thereafter, a transparent conductive material is deposited over the anti-diffusion layer **78** by sputtering process, for example. In this process step, the transparent conductive material is also deposited inside a contact hole that has been cut through the protective layer **72,** the oxygen supplying layer **74** and the anti-diffusion layer **78** over the drain electrode **70d** to contact with the drain electrode **70d** at the bottom of the contact hole. ITO may be used as the transparent conductive material. Alternatively, IZO, ZnO or any other appropriate material may also be used as the transparent conductive material. Subsequently, the transparent electrode layer is patterned by known photolithographic process, thereby forming the pixel electrodes **20.**

By performing these process steps, a TFT substrate **100** with TFTs **10** is completed.

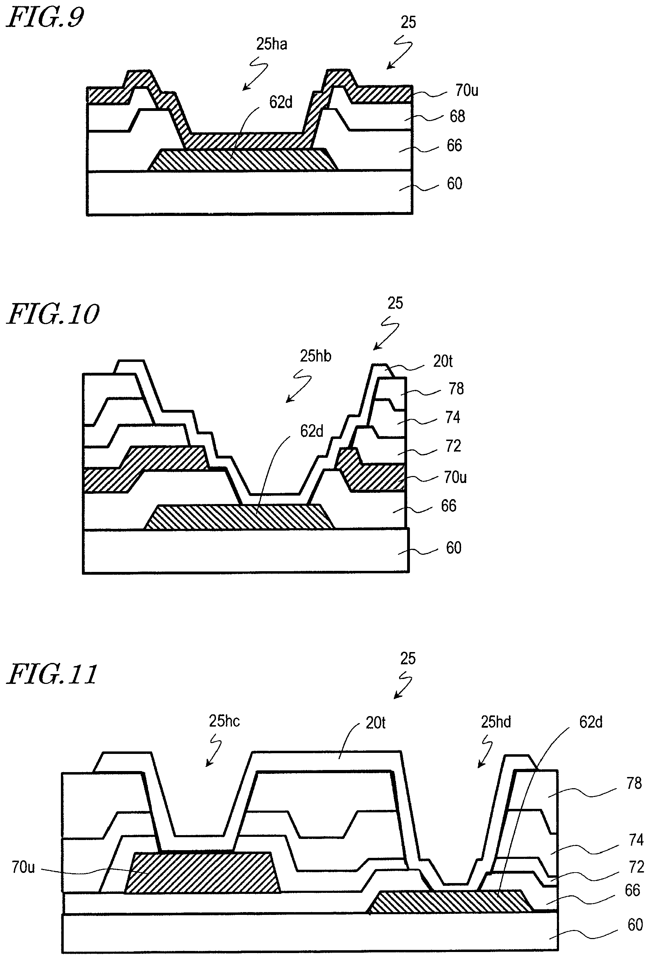

Next, first, second and third exemplary configurations for the connecting portion **25** of this TFT substrate **100** will be described with reference to FIGS. **9** through **11****,** which schematically illustrate cross sections of the connecting portion **25** with the first, second and third exemplary configurations, respectively.

### First exemplary configuration:

As shown in FIG. **9****,** the connecting portion **25** with the first exemplary configuration includes a lower wiring **62b** which has been formed on a substrate **60,** a gate insulating layer **66** which has been stacked on the lower wiring **62d,** an oxide semiconductor layer **68** which has been stacked on the gate insulating layer **66,** and an upper wiring **70u** which has been formed on the oxide semiconductor layer **68.** In one embodiment, the oxide semiconductor layer **68** may be omitted. The lower wiring **62d** is a metal layer which has been formed of the same material and at the same time as the gate electrode **62.** The upper wiring **70u** is a metal layer which has been formed of the same material and at the same time as the source and drain electrodes **70s** and **70d.**

In this connecting portion **25,** holes have been cut through the oxide semiconductor layer **68** and the gate insulating layer **66** so that these two holes are vertically continuous with each other to define a contact hole **25ha** that runs through these two layers. The hole of the gate insulating layer **66** is larger in size than that of the oxide semiconductor layer **68.** And in the contact hole **25ha,** the gate insulating layer **66** and the oxide semiconductor layer **68** have stepped side surfaces. The upper and lower wirings **70u** and **62d** are connected together through the contact hole **25ha.** In other words, the upper wiring **70u** which has been formed in the contact hole **25ha** is connected to the lower wiring **62d** at the bottom of the contact hole **25ha.** In an embodiment in which the connecting portion **25** has no oxide semiconductor layer **68,** the contact hole **25ha** is arranged to run through only the gate insulating layer **66.**

If the contact hole **25ha** has too steep a side surface while a metal layer to define the upper wiring **70u** is being deposited, then the metal layer would be easily cut off at the side surface to possibly cause disconnection at this connecting portion. In this exemplary configuration, however, the upper wiring **70u** is formed on the stepped side surfaces of the gate insulating layer **66** and the oxide semiconductor layer **68,** not on such a steep side surface, the upper wiring **70u** would not be cut off easily. As a result, a highly reliable connecting portion **25** can be obtained.

### Second exemplary configuration:

As shown in FIG. **10****,** the connecting portion **25** with the second exemplary configuration includes a lower wiring **62d** which has been formed on a substrate **60,** a gate insulating layer **66** which has been stacked on the lower wiring **62d,** an upper wiring **70u** which has been formed on the gate insulating layer **66,** a protective layer **72** which has been stacked on the upper wiring **70u,** an oxygen supplying layer **74** which has been stacked on the protective layer **72,** an anti-diffusion layer **78** which has been stacked on the oxygen supplying layer **74,** and a conductive layer **20t** which has been stacked on the anti-diffusion layer **78.** The lower wiring **62d** is a metal layer which has been formed of the same material and at the same time as the gate electrode **62.** The upper wiring **70u** is a metal layer which has been formed of the same material and at the same time as the source and drain electrodes **70s** and **70d.** And the conductive layer **20t** has been formed of the same material and at the same time as the pixel electrodes **20.**

In this connecting portion **25,** holes have been cut through the gate insulating layer **66,** the upper wiring **70u,** the protective layer **72,** the oxygen supplying layer **74,** and the anti-diffusion layer **78** so that their holes are vertically continuous with each other and increase their sizes upward (i.e., from the lowermost layer toward the uppermost layer). And a contact hole **25hb** is defined to run through these layers. In this contact hole **25hb,** the ends of those layers are arranged stepwise so that the higher the level of a layer, the outer its ends are located.

The upper and lower wirings **70u** and **62d** are connected together through the conductive layer **20t** that has been deposited in the contact hole **25hb.** That is to say, the conductive layer **20t** has been deposited in the contact hole **25hb** to cover the respective side surfaces of the gate insulating layer **66,** the upper wiring **70u,** the protective layer **72,** the oxygen supplying layer **74,** and the anti-diffusion layer **78.** The conductive layer **20t** and the upper wiring **70u** are connected together at its side surface, and the conductive layer **20t** and the lower wiring **62d** are connected together at the bottom of the contact hole **25hb.**

In forming the conductive layer **20t** in the contact hole **25hb,** a metal such as ITO or IZO is deposited by sputtering process. However, if the contact hole **25hb** had too steep a side surface, the metal layer would be cut off easily and contact between the metal layer and the upper wiring **70u** would be often insufficient. Also, if one tried to form those layers so that their ends are perfectly vertically aligned with each other, then the ends of a lower layer could be located outside of those of an upper layer due to a mask misalignment in a photolithographic process, a variation in etching shift or an overhang. In that case, the conductive layer **20t** could be disconnected.

In this exemplary configuration, however, the side surfaces of those layers are arranged so that the higher the level of a layer, the outer its ends are located. That is why the contact hole **25hb** comes to have a stepped side surface, thus preventing the conductive layer **20t** from being disconnected and also preventing the conductive layer **20t** and the upper wiring **70u** from contacting with each other insufficiently. In addition, since the respective layers that form the multilayer structure are connected together through a single contact hole, the connecting portion can have a reduced area. As a result, the TFT substrate can have a higher density and a smaller size. On top of that, the contact hole **25hb** may also be cut by etching all of those layers at a time through half-tone exposure or resist ashing process, for example. In that case, the productivity will increase and the TFT substrate can be fabricated at a lower cost as well.

### Third exemplary configuration:

As shown in FIG. **11****,** the connecting portion **25** with the third exemplary configuration includes a lower wiring **62d** which has been formed on a substrate **60,** a gate insulating layer **66** which has been stacked on the lower wiring **62d,** an upper wiring **70u** which has been formed on the gate insulating layer **66,** a protective layer **72** which has been stacked on the upper wiring **70u,** an oxygen supplying layer **74** which has been stacked on the protective layer **72,** an anti-diffusion layer **78** which has been stacked on the oxygen supplying layer **74,** and a conductive layer **20t** which has been stacked on the anti-diffusion layer **78.** The lower wiring **62d** is a metal layer which has been formed of the same material and at the same time as the gate electrode **62.** The upper wiring **70u** is a metal layer which has been formed of the same material and at the same time as the source and drain electrodes **70s** and **70d.** And the conductive layer **20t** has been formed of the same material and at the same time as the pixel electrodes **20.**

In this connecting portion **25,** a first contact hole **25hc** has been cut to run through the anti-diffusion layer **78,** the oxygen supplying layer **74,** and the protective layer **72,** and a second contact hole **25hd** has been cut to run through the anti-diffusion layer **78,** the oxygen supplying layer **74,** the protective layer **72** and the gate insulating layer **66.** The upper wiring **70u** and the conductive layer **20t** are connected together inside the first contact hole **25hc.** That is to say, in the contact hole **25hc,** the conductive layer **20t** has been deposited to cover the respective side surfaces of the anti-diffusion layer **78,** the oxygen supplying layer **74,** and the protective layer **72.** And the conductive layer **20t** and the upper wiring **70u** are connected together at the bottom of the contact hole **25hc.** On the other hand, the conductive layer **20t** and the lower wiring **62d** are connected together inside the second contact hole **25hd.** That is to say, in the contact hole **25hd,** the conductive layer **20t** has been deposited to cover the respective side surfaces of the anti-diffusion layer **78,** the oxygen supplying layer **74,** the protective layer **72** and the gate insulating layer **66.** And the conductive layer **20t** and the lower wiring **62d** are connected together at the bottom of the contact hole **25hd.**

In this manner, the upper and lower wirings **70u** and **62d** are electrically connected together via the conductive layer **20t.** As in the first and second exemplary configurations, the contact holes **25hc** and **25hd** may each have a stepped side surface. Then, it is possible to prevent the conductive layer **20t** from getting disconnected.

Hereinafter, other embodiments of the present invention will be described as second through fourteenth embodiments. In the following description, any component having substantially the same function as its counterpart of the first embodiment will be identified by the same reference numeral, and detailed description thereof will be omitted herein. The same effect can be achieved by such a component with a similar configuration to what has already been described. Any of the TFTs and TFT substrates to be described below for those other embodiments are basically replaceable with the TFT **10** and TFT substrate **100** of the first embodiment described above.

### (EMBODIMENT 2)

FIG. **12** is a cross-sectional view schematically illustrating the configuration of a TFT substrate **100** as a second embodiment. The TFT substrate **100** of this embodiment has basically the same configuration as the TFT substrate **100** of the first embodiment except for the following respects. The TFT substrate **100** of this embodiment may be used as the TFT substrate **100** of the liquid crystal display device **1000** shown in FIGS. **1** and **2****.**

As shown in FIG. **12****,** the TFT substrate **100** includes a connecting portion **25,** a TFT **10,** and a storage capacitor (Cs) **18.** The connecting portion **25** of this second embodiment has basically the same configuration as the connecting portion **25** with the second exemplary configuration of the first embodiment. In this second embodiment, however, an oxide semiconductor layer **68** is arranged between the gate insulating layer **66** and the upper wiring **70u** of the second exemplary configuration, and a contact hole **25hb** has been cut to run through the gate insulating layer **66,** the oxide semiconductor layer **68,** the upper wiring **70u,** the protective layer **72,** the oxygen supplying layer **74** and the anti-diffusion layer **78.**

In the connecting portion **25** of this embodiment, the respective layers are arranged on the side surface of the contact hole **25hb** so that the higher the level of a layer, the outer its ends are located. That is why the contact hole **25hb** comes to have a stepped side surface, thus preventing the conductive layer **20t** from being disconnected and also preventing the conductive layer **20t** and the upper wiring **70u** from contacting with each other insufficiently. In addition, since the respective wirings are connected together through a single contact hole, the connecting portion can have a reduced area. Optionally, the connecting portion **25** may have the first or third exemplary configuration of the first embodiment described above.

In the region where the storage capacitor **18** has been formed (which will be referred to herein as a "Cs region"), a storage capacitor electrode **62c,** a gate insulating layer **66,** a protective layer **72,** an oxygen supplying layer **74,** an anti-diffusion layer **78** and a storage capacitor counter electrode **20c** have been stacked one upon the other in this order on the substrate **60.** The storage capacitor electrode **62c** is made of the same material, and has been formed in the same process step, as the gate electrode **62** of the TFT **10.** And the storage capacitor counter electrode **20c** is made of the same material, and has been formed in the same process step, as the pixel electrode **20.**

Over the storage capacitor electrode **62c,** a hole has been cut through the gate insulating layer **66,** the protective layer **72** and the oxygen supplying layer **74.** And the anti-diffusion layer **78** and the storage capacitor counter electrode **20c** have been stacked in that hole, in which the anti-diffusion layer **78** contacts with the storage capacitor electrode **62c** and the storage capacitor counter electrode **20c** contacts with the anti-diffusion layer **78.** A storage capacitor is formed by the storage capacitor electrode **62c,** the storage capacitor counter electrode **20c** that faces the storage capacitor electrode **62c,** and the anti-diffusion layer **78** interposed between those two electrodes. By adopting this configuration, the gap between the two electrodes can be narrower. That is why even in a TFT substrate **100** with a multilayer structure including the oxygen supplying layer **74,** a storage capacitor **18** with large capacitance can be formed in a narrow area.

Next, a first modified example of the TFT substrate **100** according to this second embodiment will be described with reference to FIG. **13****.** The TFT substrate **100** of this first modified example has basically the same configuration as the TFT substrate **100** of the second embodiment except for the following respects. Thus, the following description will be focused on their differences.

As shown in FIG. **13****,** the TFT substrate **100** includes a connecting portion **25,** a TFT **10** and a storage capacitor (Cs) **18.** In the Cs region where the storage capacitor **18** has been formed, a storage capacitor electrode **62c,** a gate insulating layer **66,** a protective layer **72,** an oxygen supplying layer **74,** a conductive layer **22** made of a transparent electrode material (which will be referred to herein as a "first conductive layer"), an anti-diffusion layer **78** and a storage capacitor counter electrode **20c** (which will be referred to herein as a "second conductive layer") have been stacked one upon the other in this order on the substrate **60.**

Over the storage capacitor electrode **62c,** a hole has been cut through the gate insulating layer **66,** the protective layer **72** and the oxygen supplying layer **74.** And the conductive layer **22,** the anti-diffusion layer **78** and the storage capacitor counter electrode **20c** have been stacked in that hole, in which the conductive layer **22** contacts with the storage capacitor electrode **62c** and the anti-diffusion layer **78** is interposed between the conductive layer **22** and the storage capacitor counter electrode **20c.**

A storage capacitor **18** is formed by the storage capacitor electrode **62c** and the conductive layer **22,** the storage capacitor counter electrode 20c that faces the storage capacitor electrode **62c** and the conductive layer **22,** and the anti-diffusion layer **78.** By adopting this configuration, the gap between the two electrodes can be narrower. That is why even in a TFT substrate **100** with a multilayer structure including the oxygen supplying layer **74,** a storage capacitor **18** with large capacitance can be formed in a narrow area.

Next, a second modified example of the TFT substrate **100** according to this second embodiment will be described with reference to FIG. **14****.** The TFT substrate **100** of this second modified example has basically the same configuration as the TFT substrate **100** of the second embodiment except for the following respects. Thus, the following description will be focused on their differences.

As shown in FIG. **14****,** the TFT substrate **100** includes a connecting portion **25,** a TFT **10** and a storage capacitor (Cs) **18.** In the Cs region where the storage capacitor **18** has been formed, a storage capacitor electrode **62c,** a gate insulating layer **66,** an oxide semiconductor layer **68,** a protective layer **72,** an oxygen supplying layer **74,** an anti-diffusion layer **78** and a storage capacitor counter electrode **20c** have been stacked one upon the other in this order on the substrate **60.**

The upper surface of the storage capacitor electrode **62c** is not covered with the gate insulating layer **66** but contacts with the oxide semiconductor layer **68.** Over the oxide semiconductor layer **68,** a hole has been cut through the protective layer **72** and the oxygen supplying layer **74** and the anti-diffusion layer **78** and the storage capacitor counter electrode **20c** are stacked in that hole, in which the oxide semiconductor layer **68** contacts with the anti-diffusion layer **78** and the anti-diffusion layer **78** contacts with the storage capacitor counter electrode **20c.**

A storage capacitor **18** is formed by the storage capacitor electrode **62c** and the oxide semiconductor layer **68,** the storage capacitor counter electrode **20c** that faces the storage capacitor electrode **62c** and the oxide semiconductor layer **68,** and the anti-diffusion layer **78.** The oxide semiconductor layer **68** has turned into a conductor by going through a heat treatment, and therefore, functions as a storage capacitor electrode. Thus, the gap between the two electrodes can be narrower. As a result, even in a TFT substrate **100** with a multilayer structure including the oxygen supplying layer **74,** a storage capacitor **18** with large capacitance can be formed in a narrow area. In addition, the patterning and heat treatment process steps on the oxide semiconductor layer **68** in the Cs section are carried out simultaneously with the patterning and heat treatment process steps on the oxide semiconductor layer **68** of the TFT **10.** Consequently, a high-performance storage capacitor **18** can be formed efficiently without increasing the number of process steps.

### (EMBODIMENT 3)

Hereinafter, a display device as a third embodiment of the present invention will be described. A display device according to the third embodiment is a fringe field (FFS) type liquid crystal display device. In the following description, any component having substantially the same function as its counterpart of the first embodiment will be identified by the same reference numeral. And the following description will be focused on their differences.

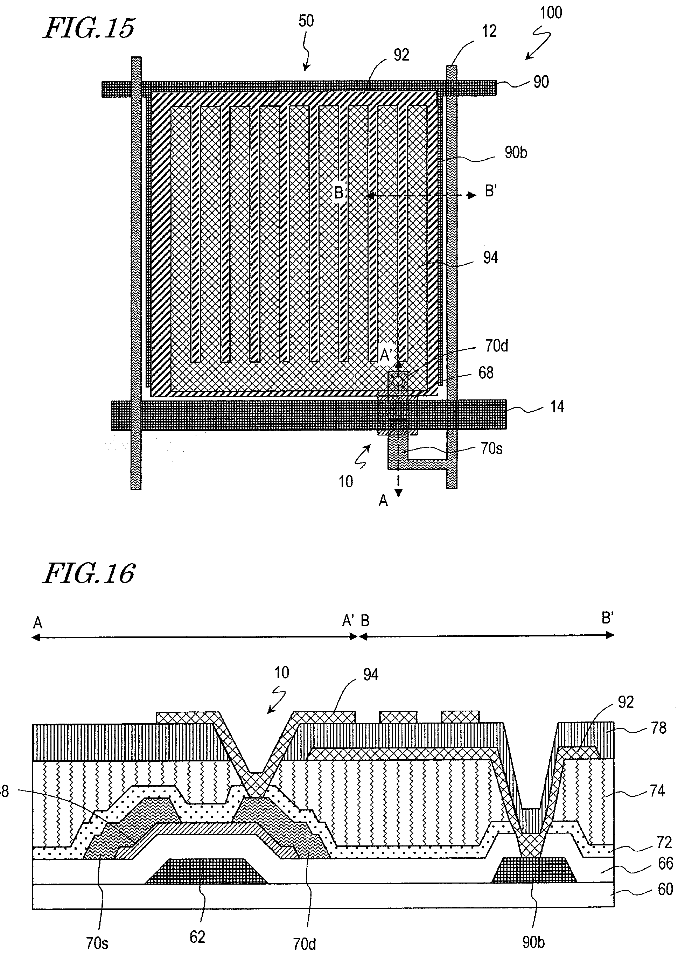

FIG. **15** is a plan view schematically illustrating a configuration for a pixel **50** of a TFT substrate **100** according to the third embodiment. FIG. **16** is a schematic cross-sectional view of the TFT substrate **100** according to the third embodiment as viewed on the plane **A-A'** (a cross section of the TFT **10**) and the plane **B-B'.**

As shown in FIGS. **15** and **16****,** each pixel **50** of the TFT substrate **100** includes a TFT **10,** an upper electrode (pixel electrode) **94** connected to the drain electrode **70d** of the TFT **10,** and a lower electrode **92.** The TFT **10** has the same configuration as the TFT **10** of the first and second embodiments described above. On the TFT substrate **100,** a common line **90** is arranged to run parallel to the scan line **14.** A region surrounded with the scan line **14,** the common line **90,** and two adjacent signal lines **12** corresponds to one pixel **50.**

A branch line **90b** is extended from the common line **90** so as to run parallel to the signal lines **12** around the pixel **50.** A contact hole has been cut through the gate insulating layer **66,** the protective layer **72** and the oxygen supplying layer **74** on the branch line **90b.** And the side surface and bottom of the contact hole are covered with a portion of the lower electrode **92.** That is to say, the lower electrode **92** and the branch line **90b** (and the common line **90**) are connected together through the contact hole. The common line **90** and the branch line **90b** are made of the same material, and formed in the same process step, as the gate electrode **62** of the TFT **10.**

The upper electrode **94** has a comb tooth shape. The lower electrode **92** is arranged between the oxygen supplying layer **74** and the anti-diffusion layer **78** to cover almost the entire pixel **50.** On the other hand, the upper electrode **92** is arranged on the anti-diffusion layer **78.** Under the electric field generated between the comb tooth portions (i.e., a plurality of linear portions that run parallel to each other) of the upper electrode **92** and the lower electrode **92,** liquid crystal molecules on the upper electrode **94** are aligned to conduct a display operation.

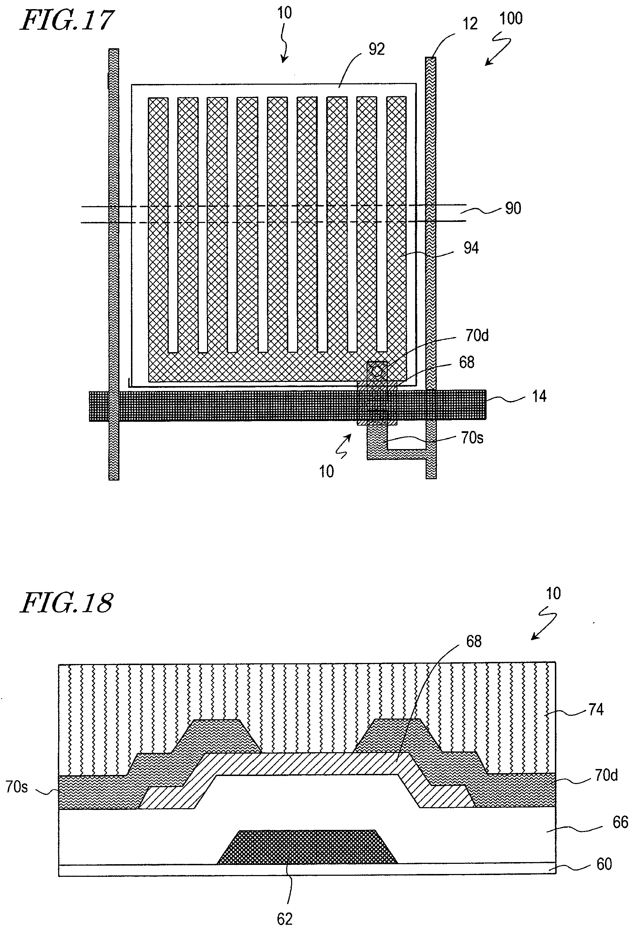

FIG. **17** is a plan view schematically illustrating a modified configuration for each pixel **50** of the TFT substrate **100** according to the third embodiment. As shown in FIG. **17****,** in this modified example, the common line **90** runs through around the middle of the pixel **10** parallel to the scan line **14,** no branch line **90b** has been formed, and the common line **90** and the lower electrode **92** are connected together through a contact hole that has been cut over the common line **90.**

### (EMBODIMENT 4)

Hereinafter, a configuration for a TFT **10** as a fourth embodiment of the present invention will be described with reference to FIG. **18****,** which schematically illustrates a cross section of the TFT **10** according to this fourth embodiment.

The TFT **10** of this fourth embodiment includes a gate electrode **62** which has been formed on a substrate **60,** a gate insulating layer **66** which has been stacked on the gate electrode **62,** an oxide semiconductor layer **68** which has been stacked on the gate insulating layer **66,** a source electrode **70s** and a drain electrode **70d** which are arranged on the oxide semiconductor layer **68,** and an oxygen supplying layer **74** which has been stacked on the oxide semiconductor layer **68** and the source and drain electrodes **70s** and **70d** to contact with a channel portion of the oxide semiconductor layer **68.** This TFT **10** includes every component of the TFT **10** of the first embodiment but the protective layer **72** and the anti-diffusion layer **78** and has the same configuration as the first embodiment other than that.

According to the configuration of this fourth embodiment, the oxygen supplying layer **74** contacts directly with the channel portion of the oxide semiconductor layer **68,** and therefore, defects in the channel portion can be repaired efficiently. Nevertheless, effects by the anti-diffusion layer **78** cannot be obtained.

### (EMBODIMENT 5)

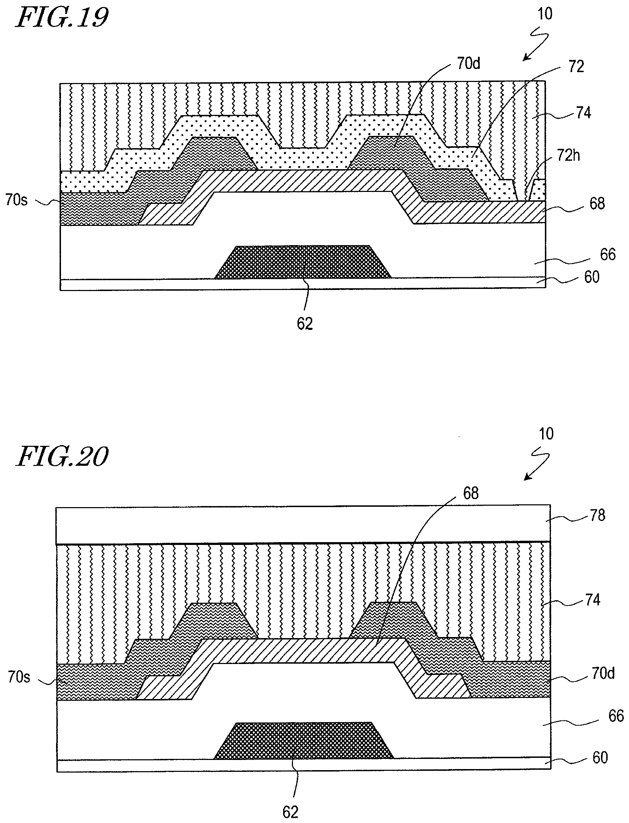

Hereinafter, a configuration for a TFT **10** as a fifth embodiment of the present invention will be described with reference to FIG. **19****,** which schematically illustrates a cross section of the TFT **10** according to this fifth embodiment.

The TFT **10** of this fifth embodiment includes a gate electrode **62** which has been formed on a substrate **60,** a gate insulating layer **66** which has been stacked on the gate electrode **62,** an oxide semiconductor layer **68** which has been stacked on the gate insulating layer **66,** a source electrode **70s** and a drain electrode **70d** which are arranged on the oxide semiconductor layer **68,** a protective layer **72** which has been stacked on the source and drain electrodes **70s** and **70d,** and an oxygen supplying layer **74** which has been stacked on the protective layer **72.** This TFT **10** includes every component of the TFT **10** of the first embodiment but the anti-diffusion layer **78,** and a contact hole **72h** has been cut through the protective layer **72.** Other than that, the TFT **10** of this embodiment has the same configuration as the first embodiment.

The contact hole **72h** is filled with the oxygen supplying layer **74,** which contacts with the oxide semiconductor layer **68** at the bottom of the contact hole **72h.** Since the oxygen supplying layer **74** and the oxide semiconductor layer **68** contact with each other in the vicinity of the channel, more H₂O can be supplied to the oxide semiconductor layer **68** than in the first embodiment. Also, if the oxygen supplying layer **74** directly contacted with the channel portion of the oxide semiconductor layer **68** as in the fourth embodiment, a lot of impurities could enter the upper surface and its surrounding region of the channel portion and other inconveniences could be caused. According to this embodiment, however, the protective layer **72** is arranged over the channel portion, and therefore, such inconveniences can be avoided and the reliability of the TFT can be increased. Nevertheless, effects by the anti-diffusion layer **78** cannot be obtained.

### (EMBODIMENT 6)

Hereinafter, a configuration for a TFT **10** as a sixth embodiment of the present invention will be described with reference to FIG. **20****,** which schematically illustrates a cross section of the TFT **10** according to the fifth embodiment.

The TFT **10** of this fifth embodiment includes a gate electrode **62** which has been formed on a substrate **60,** a gate insulating layer **66** which has been stacked on the gate electrode **62,** an oxide semiconductor layer **68** which has been stacked on the gate insulating layer **66,** a source electrode **70s** and a drain electrode **70d** which are arranged on the oxide semiconductor layer **68,** an oxygen supplying layer **74** which has been stacked on the source and drain electrodes **70s** and **70d,** and an anti-diffusion layer **78** which has been stacked on the oxygen supplying layer **74.** This TFT **10** includes every component of the TFT **10** of the first embodiment but the protective layer **72** and includes everything of the fourth embodiment plus the anti-diffusion layer **78.**

According to the configuration of this sixth embodiment, the oxygen supplying layer **74** contacts directly with the channel portion of the oxide semiconductor layer **68,** and therefore, defects in the channel portion can be repaired efficiently. In addition, effects by the anti-diffusion layer **78** can also be obtained.

### (EMBODIMENT 7)

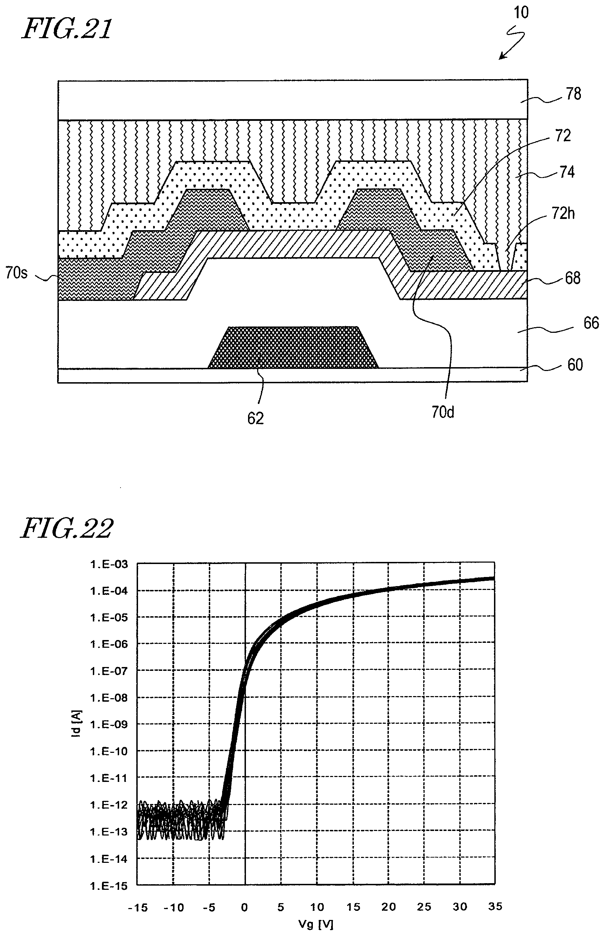

Hereinafter, a configuration for a TFT **10** as a seventh embodiment of the present invention will be described with reference to FIG. **21****,** which schematically illustrates a cross section of the TFT **10** according to the seventh embodiment.

The TFT **10** of this seventh embodiment includes a gate electrode **62** which has been formed on a substrate **60,** a gate insulating layer **66** which has been stacked on the gate electrode **62,** an oxide semiconductor layer **68** which has been stacked on the gate insulating layer **66,** a source electrode **70s** and a drain electrode **70d** which are arranged on the oxide semiconductor layer **68,** a protective layer **72** which has been stacked on the source and drain electrodes **70s** and **70d,** an oxygen supplying layer **74** which has been stacked on the protective layer **72,** and an anti-diffusion layer **78** which has been stacked on the oxygen supplying layer. This TFT **10** has the same configuration as the TFT **10** of the first embodiment except that a contact hole **72h** has been cut through its protective layer **72.** Also, this TFT **10** includes everything of the fifth embodiment plus the anti-diffusion layer **78.**

The contact hole **72h** is filled with the oxygen supplying layer **74,** which contacts with the oxide semiconductor layer **68** at the bottom of the contact hole **72h.** Since the oxygen supplying layer **74** and the oxide semiconductor layer **68** contact with each other in the vicinity of the channel portion, more H₂O and other groups can be supplied to the oxide semiconductor layer **68** than in the first embodiment. Also, if the oxygen supplying layer **74** directly contacted with the channel portion of the oxide semiconductor layer **68** as in the fourth embodiment, a lot of impurities could enter the upper surface and its surrounding region of the channel portion and other inconveniences could be caused. According to this embodiment, however, the protective layer **72** is arranged over the channel portion, and therefore, such inconveniences can be avoided and the reliability of the TFT can be increased. In addition, according to this embodiment, effects by the anti-diffusion layer **78** can also be obtained.

FIG. **22** is a graph showing the voltage-current characteristics of multiple TFTs **10** according to this embodiment. In FIG. **22****,** the abscissa represents the gate voltage value and the ordinate represents the source-drain current value. FIG. **6(a)** shows the characteristic of the first embodiment in which the protective layer **72** has no contact hole **72h** and the oxide semiconductor layer **68** does not directly contact with the oxygen supplying layer **74.** Comparing FIG. **22** to FIG. **6(a)****,** it can be seen that in the TFT **10** of the seventh embodiment, the amount of current flowing rises more steeply at a gate voltage of around 0 V, and there is less variation between the characteristics (i.e., S curves) of those TFTs **10,** than in the TFT **10** of the first embodiment. These results reveal that in any of these TFTs **10,** a more appropriate current value can be obtained with less variation in the seventh embodiment according to the voltage applied, no sooner have the TFTs **10** been turned ON. Comparing these results, it can be seen that by making the oxide semiconductor layer **68** and the oxygen supplying layer **74** directly contact with each other, a high-performance semiconductor device with further stabilized TFT characteristics can be obtained.

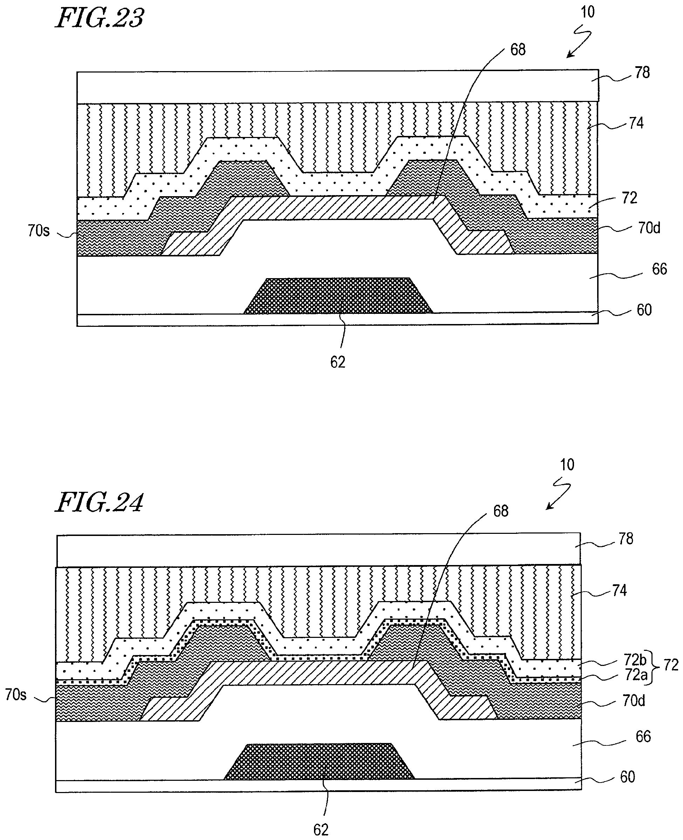

Hereinafter, eighth through thirteenth embodiments of the present invention will be described with reference to FIGS. **23** through **28****.** In those embodiments to be described below, an anti-diffusion layer **78** is supposed to be arranged on the oxygen supplying layer **74** in each TFT **10.** However, the anti-diffusion layer **78** could be omitted in some embodiment.

### (EMBODIMENT 8)

First, a configuration for a TFT **10** as an eighth embodiment of the present invention will be described with reference to FIG. **23****,** which schematically illustrates a cross section of the TFT **10** according to the eighth embodiment.

The TFT **10** of this eighth embodiment includes a gate electrode **62** which has been formed on a substrate **60,** a gate insulating layer **66** which has been stacked on the gate electrode **62,** an oxide semiconductor layer **68** which has been stacked on the gate insulating layer **66,** a source electrode **70s** and a drain electrode **70d** which are arranged on the oxide semiconductor layer **68,** a protective layer **72** which has been stacked on the source and drain electrodes **70s** and **70d,** an oxygen supplying layer **74** which has been stacked on the protective layer **72,** and an anti-diffusion layer **78** which has been stacked on the oxygen supplying layer **74.**

This TFT **10** has the same configuration as the TFT **10** of the first embodiment. However, the protective layer **72** of this embodiment has a lower density than the protective layer **72** of the first embodiment. The density of the protective layer **72** may be 2.2 g/cm³ in the first embodiment and 2.0 g/cm³ in this eighth embodiment, for example. The protective layer **72** of this eighth embodiment suitably has a density of 1.9 to 2.2 g/cm³. By setting its density to be lower than the protective layer **72** of the first embodiment, the transmittance of H₂O and other groups can be increased and more defects can be repaired in the channel portion.

### (EMBODIMENT 9)

Next, a configuration for a TFT **10** as a ninth embodiment of the present invention will be described with reference to FIG. **24****,** which schematically illustrates a cross section of the TFT **10** according to the ninth embodiment.

The TFT **10** of this ninth embodiment includes a gate electrode **62** which has been formed on a substrate **60,** a gate insulating layer **66** which has been stacked on the gate electrode **62,** an oxide semiconductor layer **68** which has been stacked on the gate insulating layer **66,** a source electrode **70s** and a drain electrode **70d** which are arranged on the oxide semiconductor layer **68,** a first protective layer **72a** which has been stacked on the source and drain electrodes **70s** and **70d,** a second protective layer **72b** which has been stacked on the first protective layer **72a,** an oxygen supplying layer **74** which has been stacked on the second protective layer **72b,** and an anti-diffusion layer **78** which has been stacked on the oxygen supplying layer **74.**

This TFT **10** has the same configuration as the TFT **10** of the first embodiment except that the protective layer **72** has a double layer structure comprised of the first and second protective layers **72a** and **72b.** The first protective layer **72a** has a higher density than the second protective layer **72b.**

The first protective layer **72a** may have a density of 2.2 g/cm³ and the second protective layer **72b** may have a density of 2.0 g/cm³, for example. The density of the first protective layer **72a** suitably falls within the range of 2.1 to 2.4 g/cm³, and the density of the second protective layer **72b** suitably falls within the range of 1.9 to 2.2 g/cm³.

If the first protective layer **72a** that contacts with the oxide semiconductor layer **68** had a low density, then its reliability as a protective layer would decrease. Thus, in this embodiment, by making a particularly important portion of the protective layer **72** around the interface with the oxide semiconductor layer **68** (e.g., a portion with a thickness of 5 to 25 nm as measured from the interface with the oxide semiconductor layer **68**) a high-density film and making the second protective layer **72b** a low-density film, the protective layer **72** is given both the function as a protective film and the property of transmitting H₂O, OR groups or OH groups adequately.

### (EMBODIMENT 10)

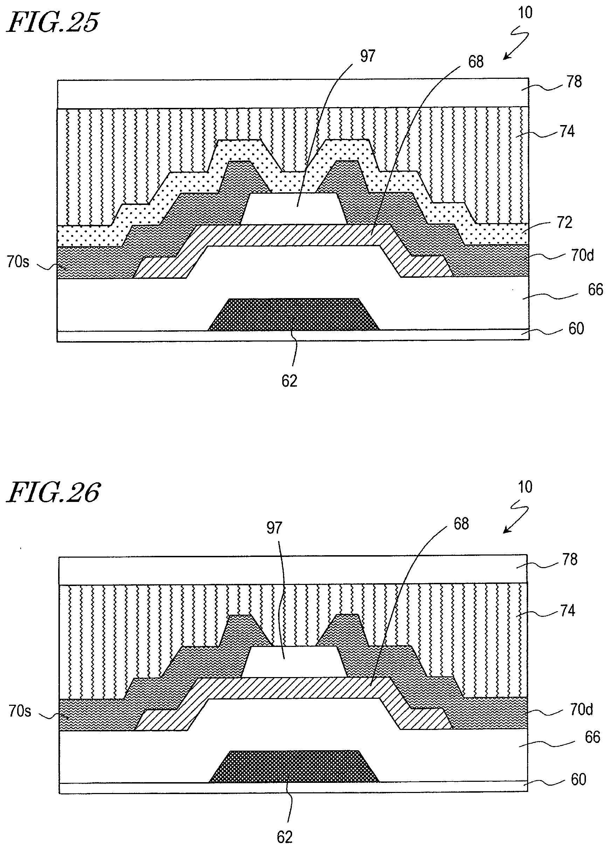

Next, a configuration for a TFT **10** as a tenth embodiment of the present invention will be described with reference to FIG. **25****,** which schematically illustrates a cross section of the TFT **10** according to the tenth embodiment.

The TFT **10** of this tenth embodiment includes a gate electrode **62** which has been formed on a substrate **60,** a gate insulating layer **66** which has been stacked on the gate electrode **62,** an oxide semiconductor layer **68** which has been stacked on the gate insulating layer **66,** an etch stopper layer (which will be referred to herein as an "ES layer") **97,** a source electrode **70s** and a drain electrode **70d** which are arranged on the oxide semiconductor layer **68,** a protective layer **72** which has been stacked on the ES layer **97** and the source and drain electrodes **70s** and **70d,** an oxygen supplying layer **74** which has been stacked on the protective layer **72,** and an anti-diffusion layer **78** which has been stacked on the oxygen supplying layer **74.**

The ES layer **97** is arranged over the channel portion of the oxide semiconductor layer **68** and between the respective ends of the source and drain electrodes **70s** and **70d.** That is to say, both ends of the ES layer **97** are overlapped by the ends of the source and drain electrodes **70s** and **70d,** and the upper surface of the central portion of the ES layer **97** contacts with the protective layer **72.** The ES layer **97** is either a silicon dioxide film or a stack of a silicon dioxide film and a silicon nitride film (which are stacked in this order so that the silicon nitride film is the upper layer). In this embodiment, the thickness of the silicon dioxide film is set to be 100 nm. By arranging the ES layer **97,** the channel portion of the oxide semiconductor layer **68** can be protected from the etch damage to be done while a metal layer to be the source and drain electrodes **70s** and **70d** is being etched. Consequently, a highly reliable TFT with a further stabilized characteristic can be obtained.

### (EMBODIMENT 11)

Next, a configuration for a TFT **10** as an eleventh embodiment of the present invention will be described with reference to FIG. **26****,** which schematically illustrates a cross section of the TFT **10** according to the eleventh embodiment.

The TFT **10** of this eleventh embodiment includes a gate electrode **62** which has been formed on a substrate **60,** a gate insulating layer **66** which has been stacked on the gate electrode **62,** an oxide semiconductor layer **68** which has been stacked on the gate insulating layer **66,** an ES layer **97,** a source electrode **70s** and a drain electrode **70d** which are arranged on the oxide semiconductor layer **68,** an oxygen supplying layer **74** which has been stacked on the ES layer **97** and the source and drain electrodes **70s** and **70d,** and an anti-diffusion layer **78** which has been stacked on the oxygen supplying layer **74.**

This embodiment has the same configuration as the tenth embodiment except that this TFT includes no protective layer **72.** The oxygen supplying layer **74** makes indirect contact with the channel portion of the oxide semiconductor layer **68** with only the ES layer **97** interposed between them. Thus, H₂O and other groups can move into the channel portion more easily, and defects in the channel portion can be repaired efficiently.

Even though two embodiments in which the TFT **10** has the ES layer **97** have been described as tenth and eleventh embodiments, these are only examples of the present invention and embodiments in which the ES layer **97** is arranged on the channel layer of any of the first through ninth embodiments described above also fall within the scope of the present invention.

### (EMBODIMENT 12)

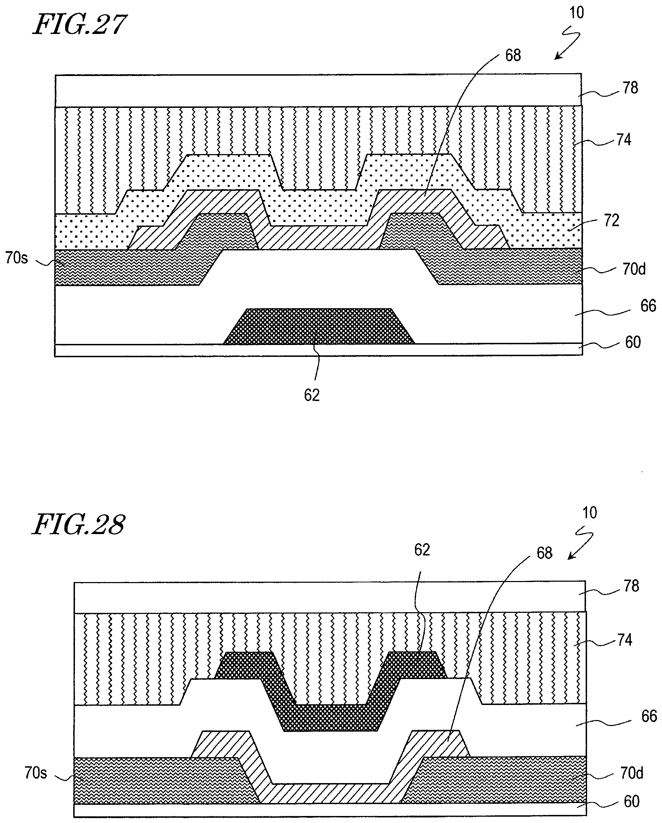

Next, a configuration for a TFT **10** as a twelfth embodiment of the present invention will be described with reference to FIG. **27****,** which schematically illustrates a cross section of the TFT **10** according to the twelfth embodiment.

The TFT **10** of this twelfth embodiment includes a gate electrode **62** which has been formed on a substrate **60,** a gate insulating layer **66** which has been stacked on the gate electrode **62,** a source electrode **70s** and a drain electrode **70d** which are arranged on the gate insulating layer **66,** an oxide semiconductor layer **68** which has been stacked on the source and drain electrodes **70s** and **70d,** a protective layer **72** which has been stacked on the oxide semiconductor layer **68,** an oxygen supplying layer **74** which has been stacked on the protective layer **72,** and an anti-diffusion layer **78** which has been stacked on the oxygen supplying layer **74.**

In this embodiment, the source and drain electrodes **70s** and **70d** are arranged between the gate insulating layer **66** and the oxide semiconductor layer **68.** However, the channel portion of the oxide semiconductor layer **68** which is interposed between the respective ends of the source and drain electrodes **70s** and **70d** is arranged so that its lower surface directly contacts with the upper surface of the gate insulating layer **66.**

According to such a configuration, the oxide semiconductor layer **68** makes indirect contact with the oxygen supplying layer **74** with only the protective layer **72** interposed between them, and neither the source electrode **70s** nor the drain electrode **70d** is sandwiched between them. Consequently, H₂O and other groups can move into the oxide semiconductor layer **68** more easily, and more defects can be repaired in the oxide semiconductor layer **68.**

### (EXAMPLE)

Next, a configuration for a TFT **10** as an example will be described with reference to FIG. **28****,** which schematically illustrates a cross section of the TFT **10** according to the example.

The TFT **10** of this example is a top gate type TFT and includes a source electrode **70s** and a drain electrode **70d** which have been formed on a substrate **60,** an oxide semiconductor layer **68** which has been stacked on the source and drain electrodes **70s** and **70d,** a gate insulating layer **66** which has been stacked on the oxide semiconductor layer **68,** a gate electrode **62** which has been formed on the gate insulating layer **66,** an oxygen supplying layer **74** which has been stacked on the gate electrode **62,** and an anti-diffusion layer **78** which has been stacked on the oxygen supplying layer **74.**

The channel portion of the oxide semiconductor layer **68** which is interposed between the respective ends of the source and drain electrodes **70s** and **70d** is arranged in contact with the substrate **60,** and the rest is arranged to overlap with the source electrode **70s** or the drain electrode **70d.** The gate electrode **62** is arranged over the central portion of the oxide semiconductor layer **68,** and the gate insulating layer **66** directly contacts with the oxygen supplying layer **74** where the gate electrode **62** is not present.

According to this configuration, H₂O and other groups can move from the oxygen supplying layer **74** into the oxide semiconductor layer **68** via the gate insulating layer **66,** and therefore, defects in the oxide semiconductor layer **68** can be repaired. In addition, since the source and drain electrodes **70s** and **70d** function as an anti-diffusion layer, the defects can be repaired even more effectively.

### (FURTHER EMBODIMENT)

Hereinafter, an organic EL display device **1002** will be described as a further embodiment of the present invention.

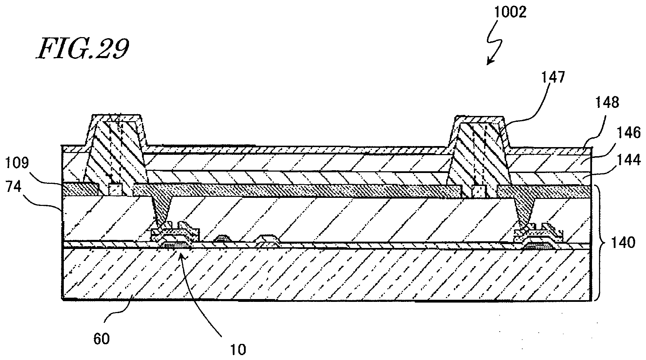

FIG. **29** is a cross-sectional view schematically illustrating a configuration for the organic EL display device **1002** (which will be sometimes simply referred to herein as a "display device **1002**"). As shown in FIG. **29****,** the display device **1002** includes a TFT substrate **140,** a hole transport layer **144** which is arranged on the TFT substrate **140,** a light-emitting layer **146** which is stacked on the hole transport layer **144,** and a counter electrode **148** which is arranged on the light-emitting layer **146.** The hole transport layer **144** and the light-emitting layer **146** together form an organic EL layer, which is divided into multiple sections by insulating projections **147.** Each divided section of the organic EL layer defines the organic EL layer of one pixel.

The TFT substrate **140** has basically the same configuration as the TFT substrate **100** according to any of the embodiments described above, and includes a TFT **10** which has been formed on the substrate **60.** The TFT **10** may be a TFT according to any of the first through twelfth embodiments described above. The TFT substrate **140** includes an interlayer insulating layer **74** which has been deposited over the TFTs **10** and a pixel electrode **109** which has been formed on the interlayer insulating layer **74.** The pixel electrode **109** is connected to the drain electrode of the TFT **10** inside a contact hole which has been cut through the interlayer insulating layer **74.** The layout of the TFT substrate **140** is basically the same as what is shown in FIGS. **2** and **3****,** and its description will be omitted herein. Optionally, a TFT substrate with no storage capacitors may also be used as the TFT substrate **140.**

When a voltage is applied to the organic EL layer by the pixel electrode **109** and the counter electrode **148,** the holes that have been generated from the pixel electrode **109** are sent to the light-emitting layer **146** via the hole transport layer **144.** In the meantime, electrons which have been generated from the counter electrode **148** also move into the light-emitting layer **146.** And those holes and electrons are recombined, thereby producing electroluminescence in the light-emitting layer **146.** And by controlling the electroluminescence produced from the light-emitting layer **146** on a pixel-by-pixel basis using the TFT substrate **140** that is an active-matrix substrate, a display operation can be carried out just as intended.

The hole transport layer **144,** the light-emitting layer **146** and the counter electrode **148** may be made of known materials and may have a known layered structure. Optionally, a hole injection layer may be provided between the hole transport layer **144** and the light-emitting layer **146** in order to increase the hole injection efficiency. To inject electrons into the organic EL layer highly efficiently while emitting the electroluminescence more efficiently, the counter electrode **148** is suitably made of a material that has high transmittance and a small work function.

The organic EL display device **1002** of this embodiment uses the TFT **10** that has been described for any of the first through twelfth embodiments, and therefore, can achieve the same effects as what has already been described for the first through thirteenth embodiments. According to this embodiment, an organic EL display device **1002** which can conduct a high quality display operation can be provided with good productivity.

### INDUSTRIAL APPLICABILITY

The present invention can be used effectively in a semiconductor device with a thin-film transistor, a display device including a thin-film transistor on its TFT substrate, such as a liquid crystal display device and an organic EL display device.

### REFERENCE SIGNS LIST

- **10**: TFT (thin-film transistor)
- **12**: signal line
- **14**: scan line
- **16**: storage capacitor line
- **18**: storage capacitor (Cs)
- **20**: pixel electrode
- **20c**: storage capacitor counter electrode
- **20t, 22**: conductive layer
- **25**: connecting portion
- **30**: terminal portion
- **50**: pixel
- **60**: substrate
- **62**: gate electrode
- **62c**: storage capacitor electrode
- **62d**: lower wiring
- **66**: gate insulating layer
- **68**: oxide semiconductor layer
- **68m**: oxide semiconductor material
- **70d**: drain electrode
- **70s**: source electrode
- **70u**: upper wiring
- **72**: protective layer
- **72h**: contact hole
- **74**: oxygen supplying layer
- **78**: anti-diffusion layer
- **90**: common line
- **92**: lower electrode
- **94**: upper electrode
- **97**: ES layer
- **100**: TFT substrate (semiconductor device)
- **200**: counter substrate
- **210, 220**: polarizer
- **230**: backlight unit
- **240**: scan line driver
- **250**: signal line driver
- **260**: controller
- **1000**: liquid crystal display device
- **1002**: organic EL display device

## Claims

1. A semiconductor device including a thin-film transistor (10), the device comprising:
a gate electrode (62) which has been formed on a substrate (60) as a part of the thin-film transistor (10);
a gate insulating layer (66) which has been formed on the gate electrode (62);
an oxide semiconductor layer (68) which has been formed on the gate insulating layer (66);
a source electrode (70s) and a drain electrode (70d) which are arranged on the oxide semiconductor layer (68) as parts of the thin-film transistor (10);
a first layer (72) which has been formed on the oxide semiconductor layer (68) and the source and drain electrodes, the first layer (72) being made of silicon dioxide or silicon nitride;
a second layer (74) which has been formed on the first layer (72), the second layer being made of an acrylic resin, an SOG material, a silicone resin, an ester polymer resin, or a resin including a silanol group, a CO-OR group or an Si-OH group; and
a third layer (78) which has been formed on the second layer, the third layer (78) being made of silicon dioxide, silicon nitride, or silicon oxynitride.

2. The semiconductor device of claim 1, comprising:
a lower wiring (62d) which is made of the same material as the gate electrode (62);
an upper wiring (70u) which is made of the same material as the source and drain electrodes (70s, 70d); and
a connecting portion (25) which connects the upper (70u) and lower wirings (62d) together,
wherein in the connecting portion (25), the upper (70u) and lower wirings (62d) are connected together through a contact hole (72h) which runs through the gate insulating layer (66).

3. The semiconductor device of claim 2, wherein in the connecting portion, the contact hole (72h) has been cut to run through the oxide semiconductor layer (68) and the gate insulating layer (66), and the upper (70u) and lower wirings (62d) are connected together through the contact hole (72h).

4. The semiconductor device of claim 2, wherein the connecting portion (25) includes:
an insulating layer which has been formed on the lower wiring (62d);
the upper wiring (70u) which has been formed on the insulating layer;
the first layer (72) which has been formed on the upper wiring;
the second layer (74) which has been formed on the first layer (72);
the third layer (78) which has been formed on the second layer (74); and
a conductive layer (20t) which has been formed on the third layer, and
wherein a contact hole (72h) has been cut to run through the insulating layer, upper wiring (70u), first layer (72), second layer (74) and third layer (78) of the connecting portion (25), and
wherein the lower (62d) and upper wirings (70u) are electrically connected together through the conductive layer (20t) that has been deposited in the contact hole (74h).

5. The semiconductor device of claim 2, wherein the connecting portion includes:
an insulating layer which has been formed on the lower wiring (62d) ;
the upper wiring (70u) which has been formed on the insulating layer;
the first layer (72) which has been formed on the upper wiring (70u);
the second layer (74) which has been formed on the first layer (72);
the third layer (78) which has been formed on the second layer (74); and
a conductive layer (20t) which has been formed on the third layer (78), and
wherein a first contact hole (72h) has been cut to run through the first layer (72), second layer (74) and third layer (78) of the connecting portion (25), and
wherein a second contact hole (72h) has been cut to run through the insulating layer, first layer (72), second layer (74) and third layer (78) of the connecting portion (25), and
wherein the upper wiring (70u) and the conductive layer (20t) are electrically connected together inside the first contact hole (74h), and
wherein the lower wiring (62d) and the conductive layer (20t) are electrically connected together inside the second contact hole (74h).

6. The semiconductor device of one of claims 1 to 5, comprising a storage capacitor (Cs) which includes:
a storage capacitor electrode (62c) which is made of the same material as the gate electrode (62);
the third layer (78) which has been formed on and in contact with the storage capacitor electrode (62c); and
a storage capacitor counter electrode (20c) which has been formed on the third layer (78).

7. The semiconductor device of one of claims 1 to 5, comprising a storage capacitor (Cs) which includes:
a storage capacitor electrode (62c) which is made of the same material as the gate electrode (62);
a first conductive layer which has been formed on and in contact with the storage capacitor electrode (62c);
the third layer (78) which has been formed on and in contact with the first conductive layer; and
a storage capacitor counter electrode (20c) which has been formed on the third layer (78).

8. The semiconductor device of one of claims 1 to 5, comprising a storage capacitor (Cs) which includes:
a storage capacitor electrode (62c) which is made of the same material as the gate electrode (62);
the oxide semiconductor layer (68) which has been formed on and in contact with the storage capacitor electrode (62c);
the third layer (78) which has been formed on and in contact with the oxide semiconductor layer (68) on the storage capacitor electrode (62c); and
a storage capacitor counter electrode (20c) which has been formed on the third layer (78).

9. A fringe field type display device (1000) comprising the semiconductor device of one of claims 1 to 8,
wherein the display device (1000) includes:
a lower electrode (92) which is arranged between the second layer (74) and the third layer (78); and
an upper electrode (94) which is arranged on the third layer (78) and connected to the drain electrode (70d) of the thin-film transistor (10).

10. The fringe field type display device of claim 9, comprising a common line (90) which is made of the same material as the gate electrode (62),
wherein the common line (90) and the lower electrode (92) are connected together through a contact hole (72h) that runs through the gate insulating layer (66), the first layer (72), and the second layer (74).

11. The semiconductor device of claim 1, wherein the first layer (72) is comprised of a first portion first layer which has been formed on the oxide semiconductor layer (68) and the source and drain electrodes, and a second portion first layer which has been formed on the first portion first layer and which has a lower density than the first portion first layer.

12. The semiconductor device of claim 1, comprising an etch stopper layer which has been formed between the oxide semiconductor layer (68) and the source and drain electrodes (70d).

13. A display device comprising the semiconductor device of claim 12.

14. The semiconductor device of one of claims 1 to 10, 13 and 12, wherein the oxide semiconductor layer (68) is made of an In-Ga-Zn-O based semiconductor (68m).

## Patentansprüche

1. Halbleitervorrichtung, umfassend einen Dünnfilmtransistor (10), wobei die Vorrichtung umfasst:
eine Gateelektrode (62), welche auf einem Substrat (60) als Teil des Dünnfilmtransistors (10) ausgebildet wurde;
eine gateisolierende Schicht (66), welche auf der Gateelektrode (62) ausgebildet wurde;
eine Oxidhalbleiterschicht (68), welche auf der gateisolierenden Schicht (66) ausgebildet wurde;
eine Sourceelektrode (70s) und eine Drainelektrode (70d), welche auf der Oxidhalbleiterschicht (68) als Teile des Dünnfilmtransistors (10) angeordnet sind;
eine erste Schicht (72), welche auf der Oxidhalbleiterschicht (68) und den Source- und Drainelektroden ausgebildet wurde, wobei die erste Schicht (72) aus Siliziumdioxid oder Siliziumnitrid hergestellt ist;
eine zweite Schicht (74), welche auf der ersten Schicht (72) ausgebildet wurde, wobei die zweite Schicht aus einem Acrylharz, einem SOG-Material, einem Silikonharz, einem Esterpolymerharz oder einem Harz hergestellt ist, das eine Silanolgruppe, eine CO-OR-Gruppe oder eine Si-OH-Gruppe enthält; und
eine dritte Schicht (78) die auf der zweiten Schicht ausgebildet wurde, wobei die dritte Schicht (78) aus Siliziumdioxid, Siliziumnitrid oder Siliziumoxynitrid hergestellt ist.

2. Halbleitervorrichtung nach Anspruch 1, umfassend:
eine untere Verdrahtung (62d), welche aus dem gleichen Material wie die Gateelektrode (62) hergestellt ist;
eine obere Verdrahtung (70u), welche aus dem gleichen Material wie die Source- und Drainelektroden (70s, 70d) hergestellt ist; und
einen Verbindungsteil (25), welcher die oberen (70u) und unteren (62d) Verdrahtungen miteinander verbindet,
wobei im Verbindungsteil (25) die oberen (70u) und unteren (62d) Verdrahtungen durch ein Kontaktloch (72h) miteinander verbunden sind, welches durch die gateisolierende Schicht (66) verläuft.

3. Halbleitervorrichtung nach Anspruch 2, wobei im Verbindungsteil das Kontaktloch (72h) so geschnitten wurde, dass es durch die Oxidhalbleiterschicht (68) und die gateisolierende Schicht (66) verläuft, und die oberen (70u) und unteren (62d) Verdrahtungen durch das Kontaktloch (72h) miteinander verbunden sind.

4. Halbleitervorrichtung nach Anspruch 2, wobei der Verbindungsteil (25) umfasst:
eine isolierende Schicht, welche auf der unteren Verdrahtung (62d) ausgebildet wurde;
die obere Verdrahtung (70u), welche auf der isolierenden Schicht ausgebildet wurde;
die erste Schicht (72), welche auf der oberen Verdrahtung ausgebildet wurde;
die zweite Schicht (74), welche auf der ersten Schicht (72) ausgebildet wurde;
die dritte Schicht (78), welche auf der zweiten Schicht (74) ausgebildet wurde; und
eine leitfähige Schicht (20t), welche auf der dritten Schicht ausgebildet wurde, und
wobei ein Kontaktloch (72h) so geschnitten wurde, dass es durch die isolierende Schicht, die obere Verdrahtung (70u), die erste Schicht (72), die zweite Schicht (74) und die dritte Schicht (78) des Verbindungsteils (25) verläuft, und
wobei die unteren (62d) und oberen (70u) Verdrahtungen durch die leitfähige Schicht (20t), die im Kontaktloch (72h) abgeschieden wurde, miteinander elektrisch verbunden sind.

5. Halbleitervorrichtung nach Anspruch 2, wobei der Verbindungsteil umfasst:
eine isolierende Schicht, welche auf der unteren Verdrahtung (62d) ausgebildet wurde;
die obere Verdrahtung (70u), welche auf der isolierenden Schicht ausgebildet wurde;
die erste Schicht (72), welche auf der oberen Verdrahtung (70u) ausgebildet wurde;
die zweite Schicht (74), welche auf der ersten Schicht (72) ausgebildet wurde;
die dritte Schicht (78), welche auf der zweiten Schicht (74) ausgebildet wurde; und
eine leitfähige Schicht (20t), welche auf der dritten Schicht (78) ausgebildet wurde, und
wobei ein erstes Kontaktloch (72h) so geschnitten wurde, dass es durch die erste Schicht (72), die zweite Schicht (74) und die dritte Schicht (78) des Verbindungsteils (25) verläuft, und
wobei ein zweites Kontaktloch (72h) so geschnitten wurde, dass es durch die isolierende Schicht, die erste Schicht (72), die zweite Schicht (74) und die dritte Schicht (78) des Verbindungsteils (25) verläuft, und
wobei die obere Verdrahtung (70u) und die leitfähige Schicht (20t) innerhalb des ersten Kontaktlochs (72h) miteinander elektrisch verbunden sind, und
wobei die untere Verdrahtung (62d) und die leitfähige Schicht (20t) innerhalb des zweiten Kontaktlochs (72h) miteinander elektrisch verbunden sind.

6. Halbleitervorrichtung nach einem der Ansprüche 1 bis 5, umfassend einen Speicherkondensator (Cs), welcher umfasst:
eine Speicherkondensatorelektrode (62c), welche aus dem gleichen Material wie die Gateelektrode (62) hergestellt ist;
die dritte Schicht (78), welche auf und in Kontakt mit der Speicherkondensatorelektrode (62c) ausgebildet wurde; und
eine Speicherkondensator-Gegenelektrode (20c), welche auf der dritten Schicht (78) ausgebildet wurde.

7. Halbleitervorrichtung nach einem der Ansprüche 1 bis 5, umfassend einen Speicherkondensator (Cs), welcher umfasst:
eine Speicherkondensatorelektrode (62c), welche aus dem gleichen Material wie die Gateelektrode (62) hergestellt ist;
eine erste leitfähige Schicht, welche auf und in Kontakt mit der Speicherkondensatorelektrode (62c) ausgebildet wurde;
die dritte Schicht (78), welche auf und in Kontakt mit der ersten leitfähigen Schicht ausgebildet wurde; und
eine Speicherkondensator-Gegenelektrode (20c), welche auf der dritten Schicht (78) ausgebildet wurde.

8. Halbleitervorrichtung nach einem der Ansprüche 1 bis 5, umfassend einen Speicherkondensator (Cs), welcher umfasst:
eine Speicherkondensatorelektrode (62c), welche aus dem gleichen Material wie die Gateelektrode (62) hergestellt ist;
die Oxidhalbleiterschicht (68), welche auf und in Kontakt mit der Speicherkondensatorelektrode (62c) ausgebildet wurde;
die dritte Schicht (78), welche auf und in Kontakt mit der Oxidhalbleiterschicht (68) auf der Speicherkondensatorelektrode (62c) ausgebildet wurde; und
eine Speicherkondensator-Gegenelektrode (20c), welche auf der dritten Schicht (78) ausgebildet wurde.

9. Anzeigevorrichtung (1000) vom Fringe-Field- bzw. Streufeldtyp, umfassend die Halbleitervorrichtung nach einem der Ansprüche 1 bis 8,
wobei die Anzeigevorrichtung (1000) umfasst:
eine untere Elektrode (92), welche zwischen der zweiten Schicht (74) und der dritten Schicht (78) angeordnet ist; und
eine obere Elektrode (94), welche auf der dritten Schicht (78) angeordnet und mit der Drainelektrode (70d) des Dünnfilmtransistors (10) verbunden ist.

10. Anzeigevorrichtung vom Fringe-Field- bzw. Streufeldtyp nach Anspruch 9, umfassend eine gemeinsame Leitung (90), welche aus dem gleichen Material wie die Gateelektrode (62) hergestellt ist,
wobei die gemeinsame Leitung (90) und die untere Elektrode (92) durch ein Kontaktloch (72h) miteinander verbunden sind, das durch die gateisolierende Schicht (66), die erste Schicht (72) und die zweite Schicht (74) verläuft.

11. Halbleitervorrichtung nach Anspruch 1, wobei die erste Schicht (72) aus einem ersten Abschnitt der ersten Schicht besteht, welcher auf der Oxidhalbleiterschicht (68) und den Source- und Drainelektroden ausgebildet wurde, und einem zweiten Abschnitt der ersten Schicht, welcher auf dem ersten Abschnitt der ersten Schicht ausgebildet wurde und welcher eine geringere Dichte als der erste Abschnitt der ersten Schicht aufweist.

12. Halbleitervorrichtung nach Anspruch 1, umfassend eine Ätzstoppschicht, welche zwischen der Oxidhalbleiterschicht (68) und den Source- und Drainelektroden (70d) ausgebildet wurde.

13. Anzeigevorrichtung, umfassend die Halbleitervorrichtung nach Anspruch 12.

14. Halbleitervorrichtung nach einem der Ansprüche 1 bis 10, 13 und 12, wobei die Oxidhalbleiterschicht (68) aus einem auf In-Ga-Zn-O basierenden Halbleiter (68m) hergestellt ist.

## Revendications

1. Dispositif semi-conducteur contenant un transistor à couches minces (10), le dispositif comprenant :
une électrode de grille (62) qui a été formée sur un substrat (60) comme une partie du transistor à couches minces (10) ;
une couche isolante de grille (66) qui a été formée sur l'électrode de grille (62) ;
une couche de semi-conducteur à oxyde (68) qui a été formée sur la couche isolante de grille (66) ;
une électrode de source (70s) et une électrode de drain (70d) qui sont disposées sur la couche de semi-conducteur à oxyde (68) comme parties du transistor à couches minces (10) ;
une première couche (72) qui a été formée sur la couche de semi-conducteur à oxyde (68) et les couches de source et de drain, la première couche (72) se composant de dioxyde de silicium ou de nitrure de silicium ;
une deuxième couche (74) qui a été formée sur la première couche (72), la deuxième couche se composant d'une résine acrylique, d'un matériau SOG, d'une résine silicone, d'une résine ester polymère ou d'une résine contenant un groupe silanol, un groupe CO-OR ou un groupe Si-OH ; et
une troisième couche (78) qui a été formée sur la deuxième couche, la troisième couche (78) se composant de dioxyde de silicium, de nitrure de silicium ou d'oxynitrure de silicium.

2. Dispositif semi-conducteur de la revendication 1, comprenant :
un câblage inférieur (62d) qui se compose du même matériau que l'électrode de grille (62) ;
un câblage supérieur (70u) qui se compose du même matériau que les électrodes de source et de drain (70s, 70d) ; et
une partie de liaison (25) qui relie les câblages supérieur (70u) et inférieur (62d) entre eux,
dans ladite partie de liaison (25) les câblages supérieur (70u) et inférieur (62d) étant reliés entre eux grâce à un perçage de contact (72h) qui traverse la couche isolante de grille (66).

3. Dispositif semi-conducteur de la revendication 2, dans lequel le perçage de contact (72h) a été réalisé pour traverser la couche de semi-conducteur à oxyde (68) et la couche isolante de grille (66), et les câblages supérieur (70u) et inférieur (62d) sont reliés entre eux grâce au perçage de contact (72h).

4. Dispositif semi-conducteur de la revendication 2, dans lequel la partie de liaison (25) contient :
une couche isolante qui a été formée sur le câblage inférieur (62d) ;
le câblage supérieur (70u) qui a été formé sur la couche isolante ;
la première couche (72) qui a été formée sur le câblage supérieur ;
la deuxième couche (74) qui a été formée sur la première couche (72) ;
la troisième couche (78) qui a été formée sur la deuxième couche (74) ; et
une couche conductrice (20t) qui a été formée sur la troisième couche, et
un perçage de contact (72h) a été réalisé pour traverser la couche isolante, le câblage supérieur (70u), la première couche (72), la deuxième couche (74) et la troisième couche (78) de la partie de liaison (25), et
les câblages inférieur (62d) et supérieur (70u) sont reliés électriquement entre eux par la couche conductrice (20t) qui a été déposée dans le perçage de contact (72h).

5. Dispositif semi-conducteur de la revendication 2, dans lequel la partie de liaison contient :
une couche isolante qui a été formée sur le câblage inférieur (62d) ;
le câblage supérieur (70u) qui a été formé sur la couche isolante ;
la première couche (72) qui a été formée sur le câblage supérieur (70u) ;
la deuxième couche (74) qui a été formée sur la première couche (72) ;
la troisième couche (78) qui a été formée sur la deuxième couche (74) ; et
une couche conductrice (20t) qui a été formée sur la troisième couche (78), et
un premier perçage de contact (72h) a été réalisé pour traverser la première couche (72), la deuxième couche (74) et la troisième couche (78) de la partie de liaison (25), et
un deuxième perçage de contact (72h) a été réalisé pour traverser la couche isolante, la première couche (72), la deuxième couche (74) et la troisième couche (78) de la partie de liaison (25), et
le câblage supérieur (70u) et la couche conductrice (20t) sont reliés électriquement entre eux à l'intérieur du premier perçage de contact (72h), et
le câblage inférieur (62d) et la couche conductrice (20t) sont reliés électriquement entre eux à l'intérieur du deuxième perçage de contact (72h).

6. Dispositif semi-conducteur de l'une des revendications 1 à 5, comprenant un condensateur de stockage (CS) qui contient :
une électrode de condensateur de stockage (62c) qui se compose du même matériau que l'électrode de grille (62) ;
la troisième couche (78) qui a été formée sur et en contact avec l'électrode de condensateur de stockage (62c) ; et
une contre-électrode de condensateur de stockage (20c) qui a été formée sur la troisième couche (78).

7. Dispositif semi-conducteur de l'une des revendications 1 à 5, comprenant un condensateur de stockage (CS) qui contient :
une électrode de condensateur de stockage (62c) qui se compose du même matériau que l'électrode de grille (62) ;
une première couche conductrice qui a été formée sur et en contact avec l'électrode de condensateur de stockage (62c) ;
la troisième couche (78) qui a été formée sur et en contact avec la première couche conductrice ; et
une contre-électrode de condensateur de stockage (20c) qui a été formée sur la troisième couche (78).

8. Dispositif semi-conducteur de l'une des revendications 1 à 5, comprenant un condensateur de stockage qui contient :
une électrode de condensateur de stockage (62c) qui se compose du même matériau que l'électrode de grille (62) ;
la couche de semi-conducteur à oxyde (68) qui a été formée sur la couche isolante de grille (66) ;
la troisième couche (78) qui a été formée sur et en contact avec la couche de semi-conducteur à oxyde (68) sur l'électrode de condensateur de stockage (62c) ; et
une contre-électrode de condensateur de stockage (20c) qui a été formée sur la troisième couche (78).

9. Dispositif d'affichage du type à champ limite (1000) comprenant le dispositif semi-conducteur de l'une des revendications 1 à 8,
le dispositif d'affichage (1000) contenant :
une électrode inférieure (92) qui est disposée entre la deuxième couche (74) et la troisième couche (78) ; et
une électrode supérieure (94) qui est disposée sur la troisième couche (78) et reliée à l'électrode de drain (70d) du transistor à couches minces (10).

10. Dispositif d'affichage du type à champ limite de la revendication 9, comprenant une ligne commune (90) qui se compose du même matériau que l'électrode de grille (62),
la ligne commune (90) et l'électrode inférieure (92) étant reliées entre elles par un perçage de contact (72h) qui traverse la couche isolante de grille (66), la première couche (72) et la deuxième couche (74).

11. Dispositif semi-conducteur de la revendication 1, dans lequel la première couche (72) se compose d'une première couche formant une première partie, qui a été formée sur la couche de semi-conducteur à oxyde (68) et les électrodes de source et de drain, et d'une deuxième couche formant une deuxième partie, qui a été formée sur la première couche formant une première partie et qui présente une densité plus faible que celle-ci.

12. Dispositif semi-conducteur de la revendication 1, comprenant une couche d'arrêt de gravure qui a été formée entre la couche de semi-conducteur à oxyde (68) et les électrodes de source et de drain (70d).

13. Dispositif d'affichage comprenant le dispositif semi-conducteur de la revendication 12.

14. Dispositif semi-conducteur de l'une des revendications 1 à 10, 13 et 12, dans lequel la couche de semi-conducteur (68) se compose d'un semi-conducteur à base de In-Ga-Zn-O (68m).
